(19) Europäisches Patentamt / European Patent Office / Office européen des brevets

(11) **EP 2 400 540 A1**

(12) **EUROPEAN PATENT APPLICATION**
published in accordance with Art. 153(4) EPC

(43) Date of publication:
**28.12.2011 Bulletin 2011/52**

(51) Int Cl.:
*H01L 23/02* (2006.01)    *G01J 1/02* (2006.01)
*H01L 23/26* (2006.01)

(21) Application number: **10743499.5**

(22) Date of filing: **27.01.2010**

(86) International application number:
**PCT/JP2010/000451**

(87) International publication number:
**WO 2010/095367 (26.08.2010 Gazette 2010/34)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **19.02.2009  JP 2009036511**

(71) Applicant: **NEC Corporation**
**Tokyo 108-8001 (JP)**

(72) Inventors:
• **YAMAZAKI, Takao**
**Tokyo 108-8001 (JP)**
• **SANO, Masahiko**
**Tokyo 108-8001 (JP)**
• **KURASHINA, Seiji**
**Tokyo 108-8001 (JP)**

(74) Representative: **Vossius & Partner**
**Siebertstrasse 4**
**81675 München (DE)**

(54) **VACUUM SEALED PACKAGE, PRINTED CIRCUIT BOARD HAVING VACUUM SEALED PACKAGE, ELECTRONIC DEVICE, AND METHOD FOR MANUFACTURING VACUUM SEALED PACKAGE**

(57)    A vacuum sealed package includes a package main body portion in which a first main body portion and a second main body portion are bonded via a hollow portion, and a getter material and an electronic device that are provided within the hollow portion, and in the state of the hollow portion being evacuated via a through-hole that brings the inside and the outside of the hollow portion into communication, the package main body portion is sealed with a sealing member, the getter material and the electronic device are connected to a first conductor pad and a second conductor pad, the first conductor pad is connected with a third conductor pad via a thermally conductive material, and the second conductor pad is electrically connected with a fourth conductor pad on a wiring substrate.

FIG. 1

EP 2 400 540 A1

## Description

TECHNICAL FIELD

The present invention relates to a vacuum sealed package that vacuum seals an electronic device, and a method for manufacturing the vacuum sealed package.

BACKGROUND ART

In recent years, there has been a demand for miniaturization, increased performance, and cost reductions for packages and devices in which an electronic device such as an infrared ray sensor, gyro sensor (angular velocity sensor), temperature sensor, pressure sensor, and acceleration sensor is vacuum-encapsulated therein. In particular, in a package or device that implements an infrared ray sensor (infrared ray receiving element) for use in a surveillance camera for night-time security or in thermography that calculates and displays temperature distribution, the inside thereof is required to be sealed with a high vacuum.

In general, infrared ray receiving elements are divided into a quantum type and a thermal type. Among these, although the thermal type has a lower level of tracking capability compared to that of the quantum type, since it is of a form that detects relative thermal quantity, it may be made in a non-cooling form and the structure thereof may be simplified. For that reason, it is possible to keep the manufacturing cost low with the thermal type.

In a package or device having this thermal-type infrared ray sensor mounted therein, an infrared ray which has been transmitted through a window is absorbed by the light-receiving portion of the detecting element, and thereby the temperature of the vicinity of the light-receiving portion changes. Further, resistance change associated with this temperature change is detected as a signal.

In order to detect a signal with a high level of sensitivity, it is necessary to thermally insulate the light receiving portion. For that reason, conventionally this thermal insulation property has been ensured by adopting a structure in which the light receiving portion is floated in an empty space, or by arranging the detecting element itself in a vacuum container.

However, once an electronic device has been sealed in a vacuum in order to ensure this thermal insulation property, there occurs a phenomenon in which gas molecules ($H_2O$ $O_2$, $N_2$, and the like) that have been adsorbed on surfaces inside the vacuum sealed package body are slowly released into the space in the package body over time, and the level of vacuum within the package body is reduced. As a result, the problem arises of the performance of the electronic device decreasing (for example, in an infrared ray sensor, the sensitivity of the output signal drops).

Therefore, in order to remedy such issues in a conventional vacuum sealed package, a material called a "getter" is mounted in the interior of the package, and so even in the case where outgassing occurs inside of the package body as described above, a drop in the vacuum level is prevented by absorbing the gas molecules with the getter.

As the material of the getter, for example, zirconium, vanadium, iron, or an alloy of these materials is used. However, when left in the atmosphere, gas molecules end up being adsorbed on the surface thereof, resulting in a saturated state in which the no more gas can be adsorbed. Therefore, prior to mounting a getter in a vacuum sealed package and vacuum encapsulating it, it is necessary to carry out a so-called "activation" process on the getter, and having completed the activation process, the getter needs to be encapsulated in the vacuum atmosphere. In the "activation" process, the getter is heated to 400°C to 900°C to discharge the molecules on the surface.

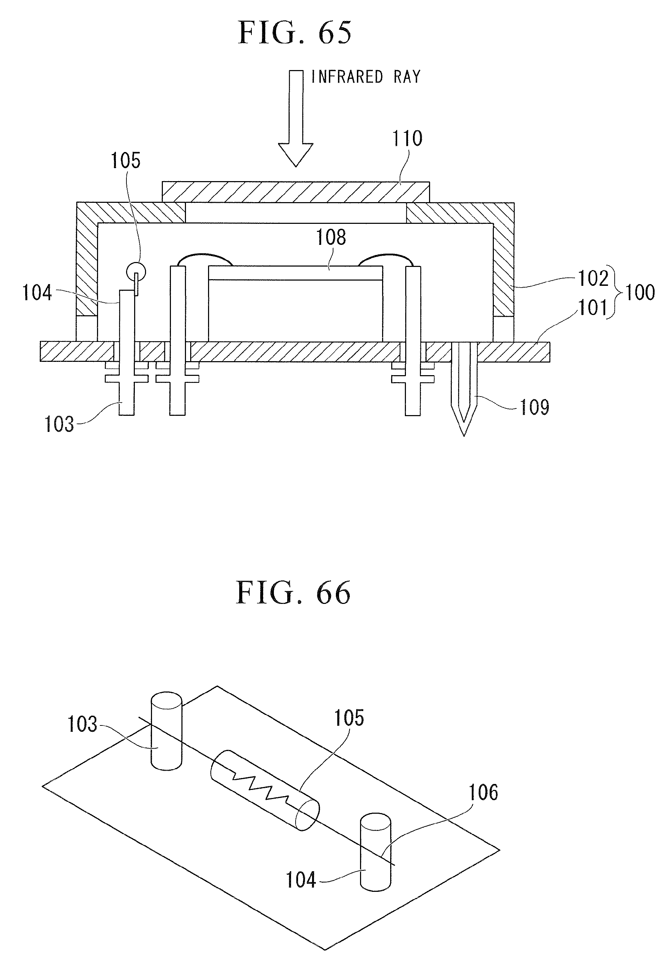

Patent Document 1 for example discloses art of a thermal-type non-cooling infrared ray sensor device having a getter mounted therein and a method for manufacturing the same. FIG. 65 shows the cross-sectional structure of a non-cooling infrared ray sensor device of Patent Document 1. In this structure, a package body 100 that serves as a vacuum package consists of a metal plate 101 and a metal cap 102. A getter 105 is connected between terminals 103 and 104 that are provided on the interior and exterior of this package body 100. By applying electrical current from the outside of the package to this terminal 104, a heater 106 that is built into the getter 105 is heated. This heater 106, as shown in FIG. 66, is electrically connected with the terminal 104, and so by applying electricity to the heater 106, simultaneously the getter 105 is heated and thereby activated.

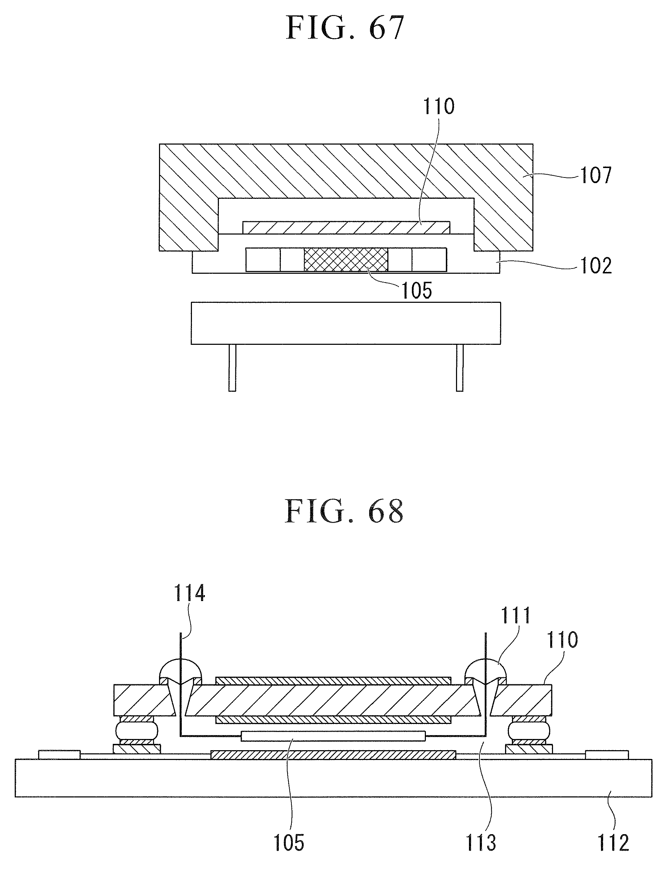

Also, Patent Document 1 discloses as another technique in which the getter 105 is bonded to the inner surface of the metal cap 102 as shown in FIG. 67, and so by bringing an external heater 107 that has been heated into contact with the metal cap 102, the getter 105 is heated and thereby activated.

Note that the device shown in FIG. 65 to FIG. 67 includes an infrared ray receiving element 108, an exhaust tube 109 for making the inside of the package body 100 a vacuum, and an infrared ray transmissive window 110 that allows transmission of infrared rays.

In addition to Patent Document 1, Patent Documents 2 and 3 also disclose thermal-type non-cooling infrared radiation sensor devices having a getter mounted therein and methods of manufacturing them.

As for the art that is disclosed in Patent Document 2, as shown in FIG. 68, a getter 105 that is wired through a through-hole 111 for vacuuming that is provided in an infrared ray transmissive window 110 is arranged in a space 113 between a substrate 112 that is integrated with a bottom plate and the infrared ray transmissive window 110, and the internal getter 105 is heated and activated by applying electricity to wiring 114 that is passed through the through-hole 111.

As for the art that is disclosed in Patent Document 3, as shown in FIG. 69, in the state of being placed in a vacuum chamber 115, the getter 105 that is installed in the infrared ray transmissive window 110 is heated by contact with the heaters 116, 117 and thereby activated, and thereafter the infrared ray transmissive window 110 and the substrate 118 above are joined in a vacuum.

Also, in addition to the Patent Documents 1 to 3 mentioned above, there is also a vacuum package technique that is disclosed in Patent Document 4. In this vacuum package, as shown in FIG. 70, a doughnut-shaped gas absorbent 121 that corresponds to the aforementioned getter is provided on a light shielding plate 120 that hangs out into the package body 100, and by emitting light energy through the upper infrared ray transmissive window 110 onto the gas absorbent 121, it adsorbs the internal gas, creating a vacuum.

[Prior Art Documents]

[Patent Documents]

[Patent Document 1] Japanese Unexamined Patent Application, First Publication No. 2003-139616
[Patent Document 2] Japanese Unexamined Patent Application, First Publication No. H11-326037
[Patent Document 3] Japanese Unexamined Patent Application, First Publication No. 2006-10405
[Patent Document 4] Japanese Unexamined Patent Application, First Publication No. 2007-073721

SUMMARY OF THE INVENTION

Problem to be Solved by the Invention

However, the conventional vacuum sealed packages shown in FIG. 65 to FIG. 70 have the following problems.

For example, in the vacuum sealed package shown in FIG. 65 and FIG. 66, it is necessary to have the heater built into the getter 105, and manufacturing of the getter cannot be automated, consequently the cost of the getter 105 itself increases. Accordingly, this leads to the problem of a rise in the cost of manufacturing a vacuum sealed package that uses it.

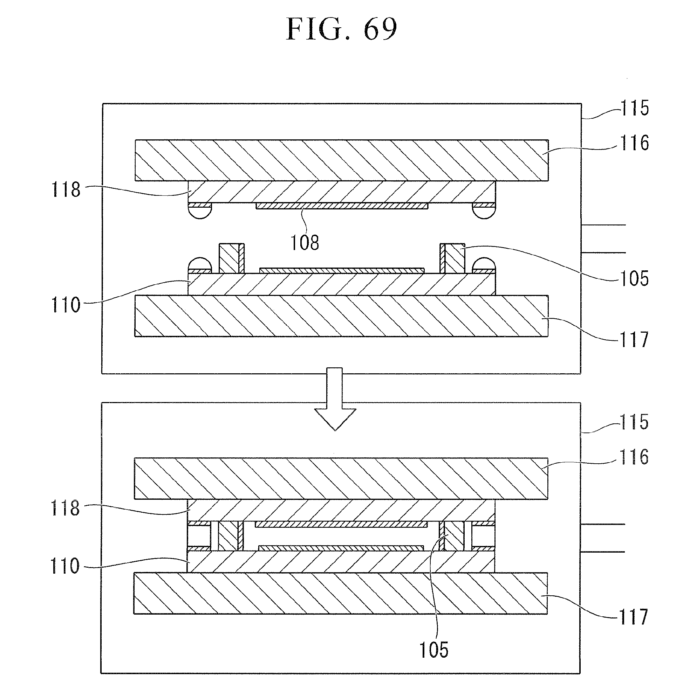

Also, in the manufacturing method for the vacuum sealed package shown in FIG. 67 or FIG. 69, a special mechanism or a robot handling mechanism or the like must be installed so as to be able to raise and lower a machine component inside the vacuum device, so that the metal cap 102 or the infrared ray transmissive window 110 can be raised or lowered in the vacuum atmosphere and can be connected to the substrate 112. Accordingly, there are the accompanying problems of the vacuum device itself becoming expensive, as well as the equipment investment cost of the manufacturing device becoming high.

Also, in the manufacturing method for the vacuum sealed package shown in FIG. 68, for each package, it is necessary to pass the wiring 114 that is connected to the getter 105 through the through-hole 11 that is formed in the infrared ray transmissive window 110. Accordingly, the level of productivity is low, and it becomes difficult to lower the manufacturing cost of a vacuum sealed package in this type of method.

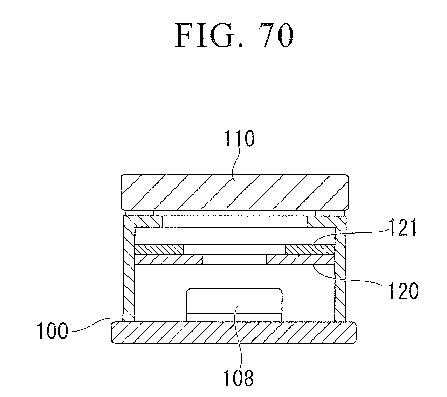

Also, although the vacuum package shown in FIG. 70 does not use a special device for the vacuum sealed package as in the aforementioned FIG. 65 to FIG. 69, it has the problem of not being able to obtain a sufficient vacuum.

Also, a vacuum sealed package in which an infrared ray sensor is installed as an electronic device is given as a representative example of a vacuum sealed package, with reference to Patent Documents 1 to 4. However, of course, even in the case of using a device other than an infrared ray sensor as the electronic device, the issues as described above are still present.

The present invention has been conceived in view of the above circumstances, and has as its object to provide a vacuum sealed package that can perform vacuum sealing of a package main body portion with a simple system and without using an expensive vacuum apparatus such as one in which a movable machine component or a robot handling mechanism or the like is provided therein in a package of a type that performs sealing of the package main body portion in a state of the interior being vacuumed beforehand, and a manufacturing method therefor. Also, it has as its object to provide a vacuum sealed package with excellent productivity that is capable of easily maintaining the vacuum state after sealing, and a method of manufacturing therefor.

Means for Solving the Problem

In order to solve the aforementioned issues, the present invention provides the following means.

That is, the present invention provides a vacuum sealed package that includes a package main body portion in which a first main body portion and a second main body portion are bonded via a hollow portion, and a getter material and an electronic device that are provided within the hollow portion of the package main body portion, and the inside of the package main body portion is sealed in the state of the hollow portion being evacuated via a through-hole that brings the inside of the hollow portion and the outside of the package main body portion into communication, in which the first main body portion includes a wiring substrate, the getter material and the electronic device are respectively connected to a first conductor pad and a second conductor pad that are positioned in the hollow portion and formed on the wiring substrate, the first conductor pad is connected via a thermally conductive material with a third conductor pad that is positioned outside of the hollow portion and formed on the wiring substrate, and the second conductor pad is electrically connected with a fourth conductor pad that is positioned outside of the hollow portion and formed on the wiring substrate.

Also, the present invention provides a vacuum sealed package that includes a package main body portion in which a first main body portion and a second main body portion are bonded via a hollow portion, and a getter material and an electronic device that are provided within the hollow portion of the package main body portion, and that in the state of the hollow portion being evacuated via a through-hole that brings the inside of the hollow portion and the outside of the package main body portion into communication, the through-hole is sealed with a sealing member, in which the sealing member is formed by partially heating the vicinity of the through-hole of the package main body portion so as to melt the vicinity of the through-hole is melted.

Effect of the Invention

According to the present invention, since the third conductor pad is positioned outside of the hollow portion of the package main body portion and is connected via a thermally conductive material with the first conductor pad that is formed on the wiring substrate that is positioned in the hollow portion of the package main body portion, after evacuating and sealing the hollow portion of the package main body portion, if for example a laser beam or the like is emitted onto the third conductor pad, the first conductor pad and a getter material on the first conductor pad are heated via the thermally conductive material. Thereby, it is possible to cause gas molecules in the hollow portion of the package main body portion to adsorb to the getter material. That is, in the present invention, after evacuating and sealing the hollow portion of the package main body portion, it is possible to heat the getter material on the first conductor pad in the hollow portion of the package main body portion via the thermally conductive material. Accordingly, in a package employing a system in which sealing of the package main body portion is performed in a state of the interior being evacuated in advance, it is possible to maintain the vacuum state after sealing of the package main body portion, and possible to significantly improve the productivity of the package with a simple system.

Also, in the present invention, since the sealing member that seals the through-hole with the inside and outside of the hollow portion of the package main body portion is constituted by partially heating the vicinity of the through-hole, and the constituent material of the package main body portion being melted, for example by making the sealing member a material with a lower melting point than the package main body portion, it is possible to perform sealing of the through-hole with a low-power laser device, and as a result it is possible to lower the manufacturing cost.

Also, in an exemplary embodiment of the present invention, the low-melting-point portion that includes a low-melting-point metal material with a lower melting point than the package main body portion is provided in the vicinity of the through-hole, and the sealing member is formed that plugs the through-hole by heating and melting the low-melting-point portion. In a conventional structure, since there is no low-melting-point metal film in the interior of the through-hole, and the main material itself of the package main body portion is exposed, a wetting defect occurs, and so more time is required in the case of plugging the interior of the through-hole. In contrast, in the exemplary embodiment of the present invention, by heating the low-melting-point portion, the low-melting-point portion wetly spreads well in the interior of the through-hole, and so there is the advantage of being able to reliably plug the through-hole. That is, in a package employing a system in which sealing of the package main body portion is performed in a state of the interior being evacuated in advance, it is possible to perform sealing of the package main body portion, and possible to significantly improve the productivity of the package with a simple system.

BRIEF DESCRIPTION OF THE DRAWINGS

FIG. 1 is a cross-sectional view that shows the state prior to plugging a though-hole in a vacuum sealed package according to a first exemplary embodiment of the present invention.

FIG. 2 is a cross-sectional view that shows the state of the through-hole plugged in the first exemplary embodiment of the present invention.

FIG. 3 is a cross-sectional view that shows a method of indirectly heating a getter material in the first exemplary embodiment of the present invention.

FIG. 4 is a cross-sectional view that shows another method of indirectly heating the getter material in the first exemplary embodiment of the present invention.

FIG. 5 is a cross-sectional view that shows a process of manufacturing the vacuum sealed package of the first exemplary embodiment of the present invention, showing the state of an electronic device provided on one main surface of a wiring substrate.

FIG. 6 is a cross-sectional view that shows a manufacturing process of the first exemplary embodiment of the present invention, showing the connected state of an electronic device and an second conductor pad on the wiring substrate.

FIG. 7 is a cross-sectional view that shows a manufacturing process of the first exemplary embodiment of the present invention, showing the state of a getter material mounted or formed on a first conductor pad.

FIG. 8 is a cross-sectional view that shows another manufacturing process of the vacuum sealed package of the first exemplary embodiment of the present invention, showing the state of the getter material having been mounted or formed on the first conductor pad on the wiring substrate.

FIG. 9 is a cross-sectional view that shows a manufacturing process of the first exemplary embodiment of the present invention, showing the state of a second main body portion (lid member) joined to the wiring substrate.

FIG. 10 is a cross-sectional view that shows a manufacturing process of the first exemplary embodiment of the present invention, showing the state of the hollow portion of the package main body portion being evacuated by a vacuum pump.

FIG. 11 is a cross-sectional view that shows a manufacturing process of the first exemplary embodiment of the present invention, showing a method of indirectly heating the getter material and activating the getter material in a vacuum.

FIG. 12 is an explanatory diagram that shows a manufacturing process of the first exemplary embodiment of the present invention, showing another method of indirectly heating the getter material and activating the getter material in a vacuum.

FIG. 13 is a cross-sectional view that shows a manufacturing process of the first exemplary embodiment of the present invention, showing the state of plugging the through-hole that is formed in the center position of the vacuum evacuated portion.

FIG. 14 is a cross-sectional view that shows a manufacturing process of the first exemplary embodiment of the present invention, showing the vacuum sealed package when completed.

FIG. 15 is a cross-sectional view of a vacuum sealed package according to a second exemplary embodiment of the present invention, showing the state prior to plugging the through-hole.

FIG. 16 is a cross-sectional view that shows the plugged state of the through-hole in the second exemplary embodiment of the present invention.

FIG. 17 is a cross-sectional view that shows a modification of the second exemplary embodiment of the present invention.

FIG. 18 is a cross-sectional view that shows the plugged state of the through-hole in the modification of the second exemplary embodiment of the present invention.

FIG. 19 is a cross-sectional view that shows another modification of the second exemplary embodiment of the present invention.

FIG. 20 is a cross-sectional view that shows the plugged state of the through-hole in the modification of the second exemplary embodiment of the present invention.

FIG. 21 is a cross-sectional view that shows a manufacturing process of the vacuum sealed package of the second exemplary embodiment of the present invention, showing the method of indirectly heating the getter material to activate it.

FIG. 22 is a cross-sectional view that shows a manufacturing process of the second exemplary embodiment of the present invention, showing a method of plugging the through-hole by melting a low-melting-point metal material at the perimeter of the through-hole.

FIG. 23 is a cross-sectional view that shows a manufacturing process of the second exemplary embodiment of the present invention, showing the state of emitting a laser beam at the low-melting-point metal material formed on the second main body portion (lid member) or on the wiring substrate.

FIG. 24 is a cross-sectional view that shows a manufacturing process of the second exemplary embodiment of the present invention, showing the state of the low-melting-point metal material plugging the through-hole.

FIG. 25 is a cross-sectional view that shows, as a modification of the second exemplary embodiment of the present invention, a structure in the case of the electronic device being an infrared ray sensor (infrared ray receiving element).

FIG. 26A is a top view that shows a vacuum sealed package according to a third exemplary embodiment of the present invention.

FIG. 26B is a top view that show a modification of the vacuum sealed package according to the third exemplary embodiment of the present invention.

FIG. 27 is a cross-sectional view that shows the joined state of the second main body portion (lid member) and the wiring substrate in the third exemplary embodiment of the present invention shown in FIG. 26A.

FIG. 28 is a cross-sectional view that shows the joined portion of the second main body portion (lid member) and the wiring substrate in the third exemplary embodiment of the present invention that is shown in FIG. 26A.

FIG. 29 is a cross-sectional view that shows a first shape of the through-hole in the vacuum sealed package of a fourth exemplary embodiment of the present invention.

FIG. 30 is a cross-sectional view that shows a second shape of the through-hole in the vacuum sealed package of the fourth exemplary embodiment of the present invention.

FIG. 31 is a cross-sectional view that shows a third shape of the through-hole in the vacuum sealed package of the fourth exemplary embodiment of the present invention.

FIG. 32 is a cross-sectional view that shows the state prior to plugging the through-hole in the vacuum sealed package of a fifth exemplary embodiment of the present invention.

FIG. 33 is a cross-sectional view that shows a method of activating the getter material in the fifth exemplary embodiment of the present invention.

FIG. 34 is a cross-sectional view that shows the state of plugging the through-hole in the fifth exemplary embodiment of the present invention.

FIG. 35 is a cross-sectional view that shows the state prior to plugging the through-hole in the vacuum sealed package of a sixth exemplary embodiment of the present invention.

FIG. 36 is a cross-sectional view that shows a method of heating and activating the getter material in the sixth exemplary embodiment of the present invention.

FIG. 37 is a cross-sectional view that shows the state of plugging the through-hole in the sixth exemplary embodiment of the present invention.

FIG. 38 is a cross-sectional view that shows a modification of the sixth exemplary embodiment of the present invention.

FIG. 39 is a cross-sectional view that shows a method of heating and activating the getter material in the modification of the sixth exemplary embodiment of the present invention.

FIG. 40 is a cross-sectional view that shows the state of the through-hole being plugged by the low-melting-point metal material that is formed at the perimeter of the through-hole in the modification of the sixth exemplary embodiment of the present invention.

FIG. 41 is a cross-sectional view that shows the state prior to plugging the through-hole in the vacuum sealed package of a seventh exemplary embodiment of the present invention.

FIG. 42 is a cross-sectional view that shows a method of activating the getter material in the seventh exemplary embodiment of the present invention.

FIG. 43 is a cross-sectional view that shows the state of plugging the through-hole in the seventh exemplary embodiment of the present invention.

FIG. 44 is a cross-sectional view that shows a method of plugging the through-hole in the seventh exemplary embodiment of the present invention.

FIG. 45 is a cross-sectional view that shows the plugged state of the through-hole in the seventh exemplary embodiment of the present invention.

FIG. 46 is a cross-sectional view that shows the state prior to plugging the through-hole in a modification of the seventh exemplary embodiment of the present invention.

FIG. 47 is a cross-sectional view that shows the state of activating the getter material in the modification of the seventh exemplary embodiment of the present invention.

FIG. 48 is a cross-sectional view that shows another modification of the seventh exemplary embodiment of the present invention.

FIG. 49 is a cross-sectional view that shows the state of activating the getter material in the other modification of the seventh exemplary embodiment of the present invention.

FIG. 50 is a cross-sectional view that shows the plugged state of the through-hole in the other modification of the seventh exemplary embodiment of the present invention.

FIG. 51 is a cross-sectional view that shows the state prior to plugging the through-hole in the vacuum sealed package of an eighth exemplary embodiment of the present invention.

FIG. 52 is a cross-sectional view that shows the plugged state of the through-hole in the eighth exemplary embodiment of the present invention.

FIG. 53 is a plan view that shows a plate member in the eighth exemplary embodiment of the present invention.

FIG. 54 is a plan view that shows a frame member in the eighth exemplary embodiment of the present invention.

FIG. 55 is a plan view that shows an infrared ray transmissive window in the eighth exemplary embodiment of the present invention.

FIG. 56 is a plan view that shows a plate member in a modification of the eighth exemplary embodiment of the present invention.

FIG. 57 is a plan view that shows a frame member in a modification of the eighth exemplary embodiment of the present invention.

FIG. 58 is a cross-sectional view that shows the plugged state of the through-hole in the modification of the eighth exemplary embodiment of the present invention.

FIG. 59 is a cross-sectional view that shows a vacuum sealed package of a ninth exemplary embodiment of the present invention.

FIG. 60 is a cross-sectional view that shows a vacuum sealed package of a tenth exemplary embodiment of the present invention.

FIG. 61 is a cross-sectional view that shows a vacuum sealed package of an eleventh exemplary embodiment of the present invention.

FIG. 62 is a cross-sectional view that shows the state prior to plugging the through-hole in vacuum sealed package of a twelfth exemplary embodiment of the present invention.

FIG. 63 is an explanatory diagram that shows a printed substrate of a thirteenth exemplary embodiment of the present invention.

FIG. 64 is an explanatory diagram that shows a modification of the thirteenth exemplary embodiment of the present invention.

FIG. 65 is a cross-sectional view that shows a first example of a conventional vacuum sealed package.

FIG. 66 is an explanatory diagram that shows a getter used in the first example of the conventional vacuum sealed package.

FIG. 67 is a cross-sectional view that shows a second example of a conventional vacuum sealed package.

FIG. 68 is a cross-sectional view that shows a third example of a conventional vacuum sealed package.

FIG. 69 is a cross-sectional view that shows a fourth example of a conventional vacuum sealed package. FIG. 70 is a cross-sectional view that shows a fifth example of a conventional vacuum sealed package.

EXEMPLARY EMBODIMENTS FOR CARRYING OUT THE INVENTION

[Exemplary Embodiment 1]

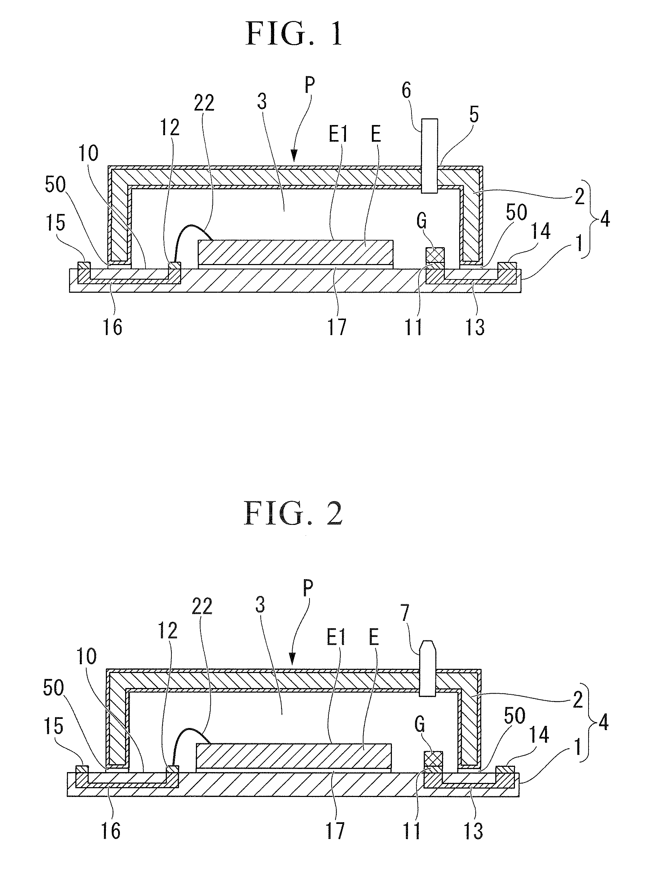

Hereinbelow, a vacuum sealed package in a first exemplary embodiment of the present invention shall be described with reference to FIG. 1 to FIG. 4.

First, in these figures, FIG. 1 is a cross-sectional view that shows the state in which the inside of a package that has been evacuated by an exhaust tube. FIG. 2 is a cross-sectional view that shows the sealed state of a package that has been evacuated.

In these figures, a vacuum sealed package P includes a package main body portion 4 in which a first main body portion 1 with a wiring substrate 10 (described below) integrated on the upper surface thereof and a second main body portion 2 that serves as a lid member are joined with a hollow portion 3 interposed therebetween, and a getter material G and an electronic device E that are provided in the hollow portion 3 within this package main body portion 4.

A through-hole 5 that brings the hollow portion 3 and the outside of the package main body 4 into communication is formed in the package main body portion 4, and the inside of the hollow portion 3 is evacuated by a vacuum exhaust tube 6 (FIG. 1) that is inserted into the through-hole 5. After performing evacuation by the vacuum exhaust tube 6, the through-hole 5 is closed by a sealing member 7, and the vacuum state is maintained.

The wiring substrate 10 is positioned in the hollow portion 3 of the package main body portion 4 and provided on the upper surface of the first main body portion 1. The getter material G that serves as an adsorbent material for gas molecules ($H_2O$ $O_2$, $N_2$, and the like) and the electronic device E are provided on the wiring substrate 10.

The getter material G and the electronic device E are respectively connected to a first conductor pad 11 and a second conductor pad 12 that are formed on the wiring substrate 10. The first conductor pad 11 is connected via a thermally conductive material 13 to a third conductor pad 14 that is positioned on the outside of the hollow portion 3 and formed on the wiring substrate 10. The second conductor pad 12 is electrically connected via a wire 16 to a fourth conductor pad 15 that is positioned on the outside of the hollow portion 3 of the package main body portion 4 and formed on the wiring substrate 10.

The getter material G is positioned on the same surface as the main surface of the wiring substrate 10 (the surface on which the electronic device E is mounted), and is mounted or is directly formed on the first conductor pad 11 that is formed in the hollow portion 3. The getter material G is provided in order to prevent a minute amount of gas molecules ($H_2O$ $N_2$, $O_2$, Ar and the like) that had adsorbed on the inner surfaces of the vacuum sealed package main body portion 4 (the inner surfaces of the first main body portion 1 or the second main body portion 2), after manufacture of the vacuum sealed package P, being released into the package hollow portion 3 and the degree of the vacuum being reduced. Prior to performing vacuum sealing, the inside of the package main body portion 4 is sufficiently evacuated, and the gas molecules that are adsorbed onto the inner surfaces of the package main body portion 4 are as much as possible removed by baking. However, even still there is a possibility of gas molecules that could not be fully removed being emitted within the hollow portion 3 over a long period, but the getter material G adsorbs them, and thereby prevents a reduction in the level of vacuum in the package main body 4.

There are no particular restrictions on the getter material G, and for example it is possible to use zirconium, titanium, vanadium, iron or an alloy that includes these.

Moreover, the first conductor pad 11 that the getter material G is mounted on is provided on the principal surface of the wiring substrate 10 and the same surface as the surface on which the electronic device E and the getter material G are mounted. The first conductor pad 11 is connected with the third conductor pad 14 that is formed on the outside of the package hollow portion 3 via a thermally conductive material 13.

As the thermally conductive material 13, it is preferable to use a metallic material that has Cu, Al, Au, Ag, Pd, or Pt, for example, as a major component. It is preferable that the perimeter of this thermally conductive material 13 be surrounded with an insulating material such as glass ceramics, alumina, and glass. Generally a metallic material that has Cu, Al, Au, Ag, Pd, Pt, or the like as a major component has high thermal conductivity, while an insulating material such as glass ceramics, alumina, and glass generally has low thermal conductivity. For this reason, in the case of heating the third conductor pad 14 that is positioned on the outside of the package main body portion 4, heat can be efficiently transmitted to the getter material G on the first conductor pad 11 via the thermal conductive material 13, and so it is possible to indirectly heat the getter material G.

Also, by using the circuit substrate 10 that uses glass ceramics, alumina, and glass as the insulating material in this way, it is possible to realize a package that is highly reliable over a long period. The reason for this is that the coefficient of linear expansion of the aforementioned insulating material is small (approximately 3 to 4 ppm), and so the difference of the coefficient of linear expansion between the wiring substrate 10 and the electronic device E (in which a circuit is generally formed with Si serving as a base substrate) is small.

When using the aforementioned insulating material, compared to the case of using a resin material, outgassing that occurs from the insulating material is less, and so there is the advantage of being able to prevent a worsening of the vacuum after manufacturing the vacuum sealed package.

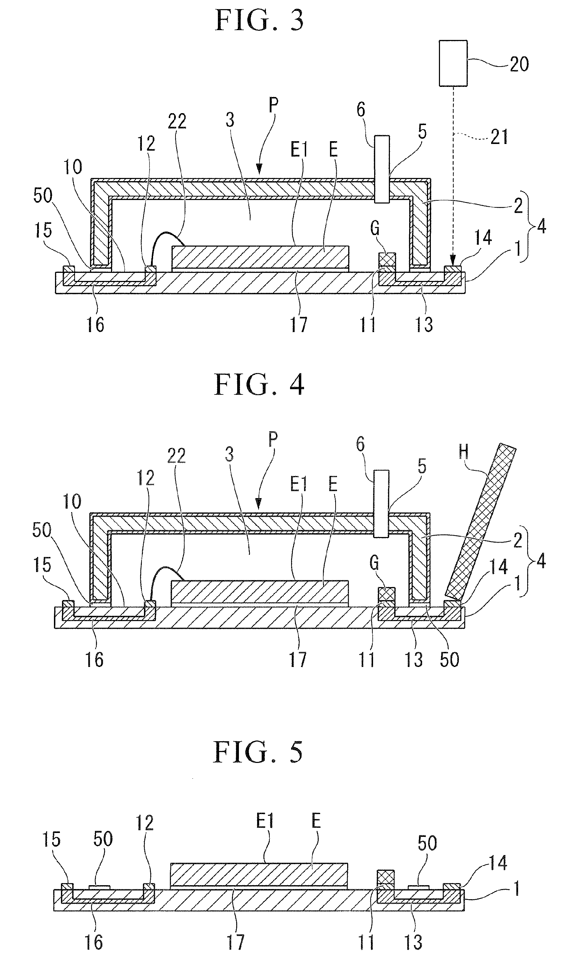

As the method of heating the third conductor pad 14, it is possible to use a method that directly emits a laser beam 21 from a laser light source 20 onto the third conductor pad 14 (FIG. 3), or a method that directly brings a heated metallic heater or a ceramic heater H into contact with the third conductor pad 14 (FIG. 4).

Since the metallic material having Cu, Al, Au, Ag, Pd, or Pt as its main component that is used as the thermally conductive material 13, and the insulating material such as glass ceramics, alumina, and glass have high upper temperature limits, even if exposed at the temperature and time required for activating the getter material G (approximately 400°C to 900°C and approximately 10 seconds to 10 minutes), no deformation or alternation occurs.

The electronic device E generally has a rectangular plate shape, and is provided on the principal surface of the first main body portion 1, which is inside the hollow portion 3 of the package main body portion 4. The electronic device E is fixed to the principal surface of the first main body portion 1 via a bonding material such as an epoxy resin-based adhesive film and metallic solder material (omitted in the drawing).

When fixing the electronic device E and the wiring substrate 10 via an adhesive or bonding material, a metal material 17 such as for example Cu, Ni, Au, Al, Pd or the like is formed on the surface of the wiring substrate 10. This is in order to raise the adhesive strength between the insulating material used for the wiring substrate 10 and the adhesive or bonding material. Depending on what kind of material is used for the insulating material that is used for the wiring substrate 10, since the adhesive strength with the adhesive or bonding material differs, there are cases in which it is acceptable to not form the metal material 17 depending on the selection conditions of the materials.

Also, the electronic device E is electrically connected with the second conductor pad 12 that is formed on the principal surface of the wiring substrate 10 that is positioned in the hollow portion 3 and on the same surface as the surface on which the electronic device E is mounted. For example, in the example shown in FIG. 1, the electronic device E and the second conductor pad 12 are electrically connected by a wire 22 that has Al, Au or the like as its main material. FIG. 1 and FIG. 2 show a structure that electrically connects an external terminal of the electronic device E and the second conductor pad 12 by the wire 22, but the method of electrical connection is not particularly constrained.

It is also possible to use a TAB tape connection method, or a method that connects with metal bumps such as solder bumps or Au bumps, using a flip-chip mounting that mounts the circuit formation surface E1 of the electronic device E so as to face the wiring substrate 10.

The second conductor pad 12 is electrically connected with the fourth conductor pad 15 that is formed on the wiring substrate 10 and positioned outside of the hollow portion 3. Using this fourth conductor pad, the connection of the vacuum sealed package and a motherboard substrate, or a module substrate is performed. This electronic device E is not particularly restricted, and it is possible to use for example a memory element (memory) such as DRAM or flash memory, various types of arithmetic processing devices (processor), a power supply element, a sensor element (infrared ray sensor, gyro sensor (angular velocity sensor), temperature sensor, pressure sensor, acceleration sensor, and oil pressure sensor), or the like.

The material of the first main body portion 1 and the second main body portion 2 that constitute the vacuum sealed package main body portion 4 is not particularly limited, but it is preferable that it be a material that hinders the discharge of gas after being vacuum sealed. Specifically, it is preferable that the first main body portion 1 and the second main body portion 2 be a semiconductor material such as Si or Ge, a metal such as Ni, Fe, Co, Cr, Ti, Au, Ag, Cu, Al, Pd, Pt or the like, an alloy material that has these as a primary component thereof, or a glass or ceramics material such as $SiO_2$ or $Al_2O_3$ or the like. It is preferable to avoid use of a resin material for the material of the main body portions 1 and 2. This is because a resin material easily absorbs moisture, and the water molecules can easily be discharged into the package main body portion 4 after being vacuum sealed.

Also, it is preferable that the package main body portion 4, in particular the second main body portion 2 be manufactured from an alloy material (such as kovar and alloy 42 or the like) that contains at least Ni. Since an alloy material such as kovar and alloy 42 that contains at least Ni has a low coefficient of linear expansion (approximately 3 to 4 ppm), it is possible to realize a package with a high level of long-term reliability. Moreover, since an alloy material such as kovar and alloy 42 is a magnetic body, it has a magnetic shielding effect. As a result, no electromagnetic interference from another electronic device mounted outside the structure that encapsulates the electronic device E is received, and so there is the advantage that stable operation can be realized. Conversely, in the case of the electronic device E that is encapsulated in the structure emitting a strong electromagnetic wave, there is also the advantage of being able to prevent electromagnetic interference to other electronic devices that are mounted outside of the package main body portion 4. Moreover, since these materials are metallic materials and are electric conductors, in the case where a metallic layer (metallic film) of a different type than those materials, needs to be formed on the surface, there is the advantage of being able to use an electro (electrolytic) plating method that can form a thick metallic layer in a shorter period of time and at a lower cost compared to those of the sputtering method and vapor deposition method.

The first main body portion 1 and the second main body portion 2 may be bonded via a solder material such as Sn, Pb, SnPb, SnAg, SnCu, SnAgCu, SnIn, SnZn, SnBi, SnZnBi, Bi, In, InAg or the like. In this case, it is preferable to form in advance, on the surface of the portion where the first main body portion 1 and the second main body portion 2 are bonded with each other, by means of a sputtering method, a vapor deposition method, or a plating method Ni, NiP, Au, Cu, Ag, Fe, Co, Pd, Ti, Cr, Pt, which prevents solder diffusion or promotes solder wettability, or an alloy with any of these materials serving as a primary component thereof. The aforementioned solder material is supplied between these metallic films, and it is heated and melted using a reflow furnace, a hot plate, or the like, to thereby connect the first main body portion 1 and the second main body portion 2.

There are also several other methods of connecting the first main body portion 1 and the second main body portion 2 that do not use the aforementioned solder material. For example, in the case of the combination of materials constituting the first main body portion 1 and the second main body portion 2 being Si-Si, $SiO_2$-$SiO_2$, Si-glass, glass-glass or the like, they may be directly bonded by anodic bonding or the like. Also, in the case of Si-Si, glass-glass, metal-metal or the like, surface activated bonding may also be employed. Also, in the case of a metal-metal combination, in addition to surface activated bonding, bonding may be conducted by means of a thermal compression bonding method or a welding method. Also, by forming an Au film on the surfaces of the first main body portion 1 and the second main body portion 2, the first main body portion 1 and the second main body portion 2 may be bonded in a process of an Au-Au thermal compression bonding, an ultrasonic bonding, a surface activated bonding, or the like.

The through-hole 5 for evacuation is formed in the second main body portion 2 as described above. FIG. 1 shows the package main body portion 4 in the state prior to vacuum sealing, with the through-hole 5 provided in the ceiling surface of the second main body portion 2 that serves as a lid member. The vacuum exhaust tube 6 having a cylindrical shape or rectangular columnar shape that is joined and integrated with the second main body portion 2 is connected via this through-hole 5.

This vacuum exhaust tube 6 evacuates the inside of the package main body portion 4 by being connected with a vacuum pump 24 (described below) via a pipe 23, in the state of being connected to the through-hole 5 of the second main body portion 2.

It is preferable that the vacuum exhaust tube 6 be made of a metallic material that has Cu, Al or the like as a main component, and be joined in an air-tight manner by welding with the second main body portion 2.

FIG. 1 shows the vacuum exhaust tube 6 and the through-hole 5 being formed at the ceiling surface of the second main body portion 2, but the vacuum exhaust tube 6 may also be formed at a side surface of the second main body portion 2 or at the wiring substrate 10.

After evacuation, the vacuum exhaust tube 6 is left connected with the vacuum pump 24, and by metal press sealing a portion of the vacuum exhaust tube 6 by a crimping method or the like, a seal member 7 is formed, whereby the vacuum seal package P is manufactured.

Note that the reference symbol 50 in the aforementioned first exemplary embodiment denotes a conductor pattern, but this shall be described in third exemplary embodiment below.

Next, the manufacturing method of the vacuum sealed package in the present exemplary embodiment constituted in this way shall be described.

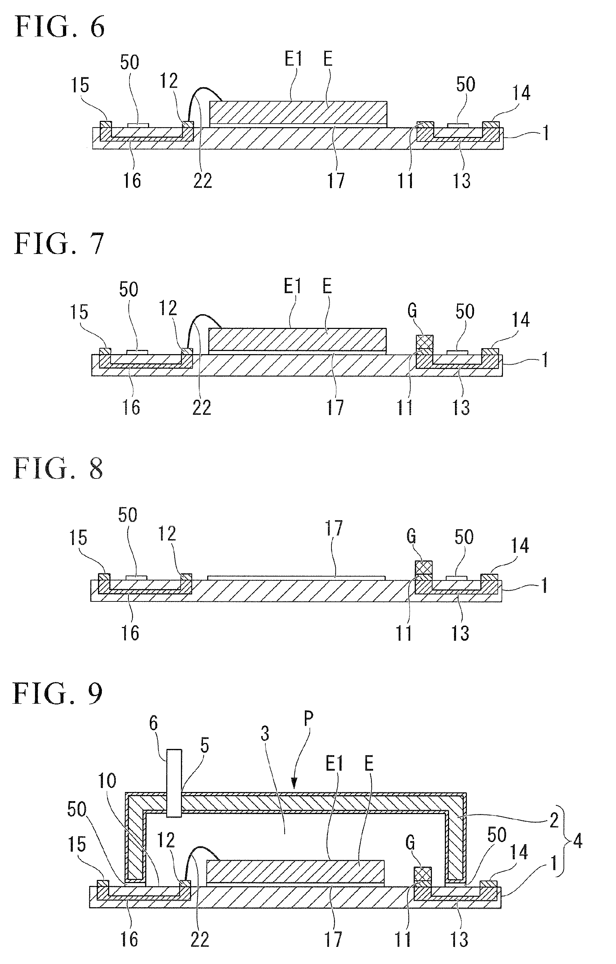

First, as shown in FIG. 5, an electronic-device E is mounted (adhesively fixed) on the wiring substrate 10 (on the metallic material 17 formed on the wiring substrate 10 in FIG. 5) using a bonding material such as an epoxy resin-based adhesive film and metallic solder material. Next, as shown in FIG. 6, the external terminal 20 of the electronic device E and the second conductor pad on the wiring substrate 10 are electrically connected. In FIG. 6, the electrical connection of the external terminal 20 of the electronic device E and the second conductor pad on the wiring substrate 10 is depicted as a bonding with the wire 22 that has Al or Au as the main material, but it is not particularly limited and both may be electrically connected by another means.

Next, the getter material G that for example has zirconium, vanadium, iron, or an alloy thereof as a main component is mounted on the first conductor pad 11 on the wiring substrate 10 using a conductive material such as an electroconductive adhesive or the like (omitted in FIG. 7). Although the main portion of the getter material G is a thin film material, it is possible to use one that is formed on a substrate, such as Si or a metal, so as to be readily mounted. These substrate materials have a high thermal conductivity, and so when performing the activation process on the getter described below, it is possible to efficiently transmit the heat that has traveled to the first conductor pad 11 to the main portion (the thin film portion) of the getter material G.

In FIG. 5 to FIG. 7, after electrically connecting electronic device E with the wiring substrate 10, the getter material G is mounted. However, the getter material G may first of all be mounted on the first conductor pad 11 on the wiring substrate 10 as shown in FIG. 8, or it may be directly formed on the first conductor pad 11 by a sputtering method or a vacuum deposition method.

Next, as shown in FIG. 9, the wiring substrate 10 and the second main body portion 2 are joined in the state of the electronic device E being housed in the hollow portion 3 that is surrounded by the wiring substrate 10 and the second main body portion 2 that serves as a lid member. An example of the joining method is as described above. As shown in FIG. 9, the vacuum exhaust tube 6 in which the through-hole 5 that penetrates from the inside to the outside of the hollow portion of the package main body portion 4 is provided in the center is joined to the second main body portion 2.

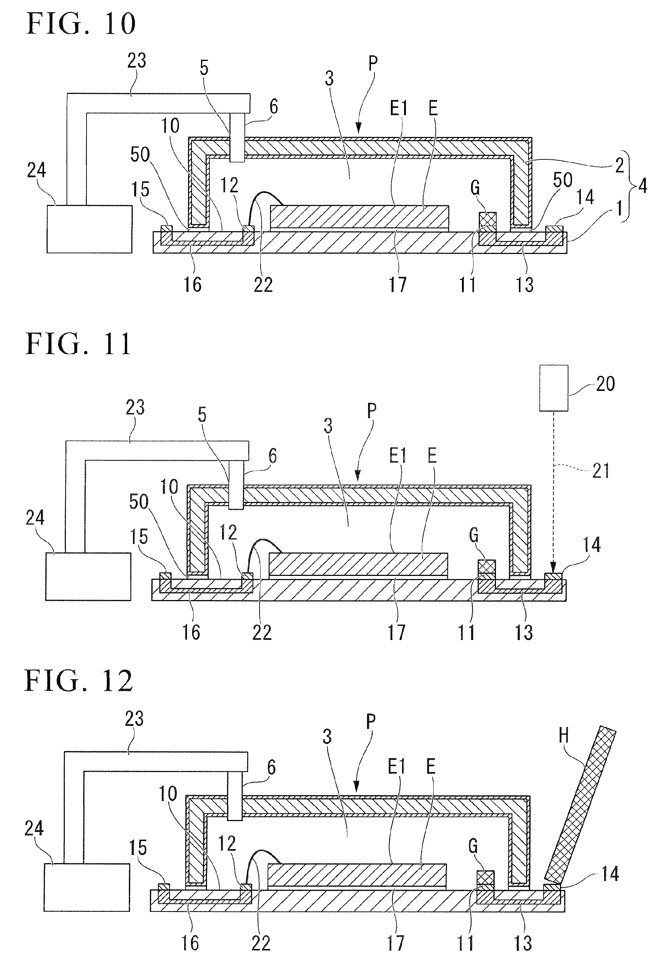

Next, as shown in FIG. 10, the vacuum exhaust tube 6 and the vacuum pump 24 are connected through the vacuum pipe 23, and hollow portion 3 in the package body portion 4 is evacuated. A rotary pump, an oil diffusion pump, a cryopump, a turbo-molecular pump, or a combination of these pumps is used for a rough vacuum in the vacuum pump 24.

In the case of using an infrared ray sensor (infrared ray receiving element) for the electronic device E, since a high vacuum of approximately $10^{-6}$ Torr to $10^{-7}$ Torr ($10^{-4}$ Pa to $10^{-5}$ Pa) or less is generally required or preferred as the level of vacuum directly after vacuum sealing, it is preferable to prepare a vacuum pump by combining a rotary pump and a cryopump, or combining a rotary pump and a turbo-molecular pump.

Also, after the achieved level of vacuum has entered the range of approximately $10^{-4}$ Pa, in order to discharge chiefly water molecules that adhere to the surface of the hollow portion 3 of the package main body portion 4 and perform evacuation, it is preferable to also incorporate a baking step that heats the package main body portion 4 to approximately 100°C to 200°C or more. Also, this baking step may also be performed after the getter activation step described below.

Next, as shown in FIG. 11, a laser beam 21 is emitted onto the third conductor pad 14 on the wiring substrate 10 using a laser light source 20. Thereby, the third conductor pad 14 is heated, and the heat is transmitted to the first conductor pad 11 through the thermally conductive material 13 to heat the getter material G that is mounted or formed on the first conductor pad. It is possible to use a carbon dioxide gas laser, a YAG laser, an excimer laser, or the like for the laser light source 20.

Moreover, as shown in FIG. 12, the third conductor pad 14 may be heated by bringing the heated heater H into contact with the third conductor pad 14 on the wiring substrate 10. Thereby, the heat is similarly transmitted to the first conductor pad 11 via the thermally conductive material 13, and it is possible to heat the getter material G that is mounted or formed on the first conductor pad.

Generally it is necessary to heat the getter material G to about 400°C to 900°C. Accordingly, in the indirect heating method that uses the laser beam 21 as shown in FIG. 11 or the indirect heating method that uses the heater H as shown in FIG. 12, the conditions for the getter material G to become approximately 400°C to 900°C (in the case of laser beam irradiation, power, beam diameter, irradiation time, and in the case of heater heating, the temperature of the heater) are found in advance. Although differing depending on the target temperature, the time required for activation of the getter material G (for discharging the molecules adsorbed on the surfaces) is in the range of several 10s of seconds to 10 minutes. The higher the temperature, the shorter the activation time.

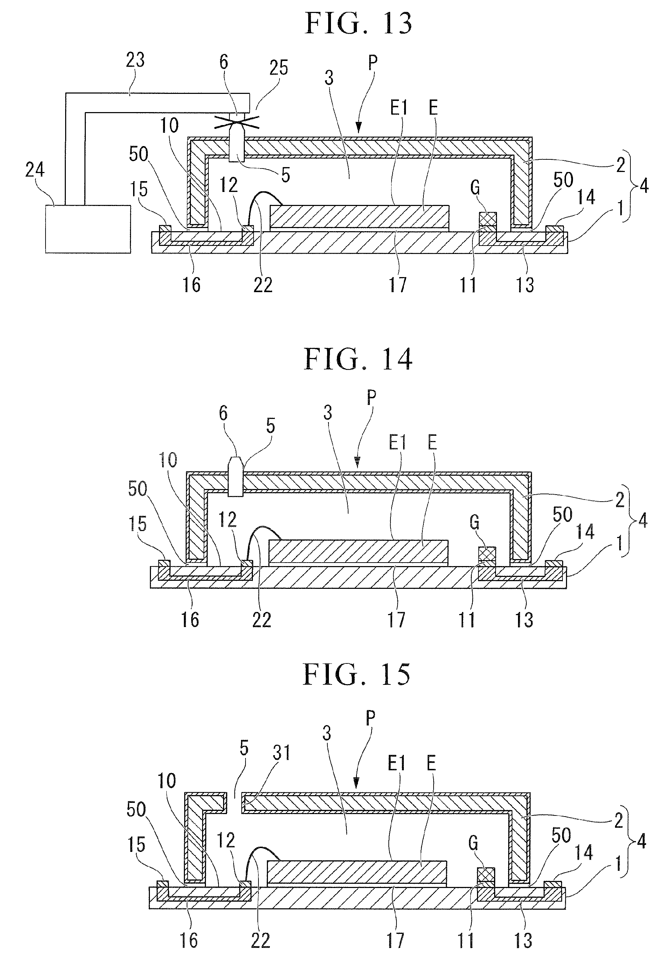

Next, the vacuum exhaust tube 6 is crimped using a crimping tool 25 as shown in FIG. 13, and vacuum sealing of the interior of the hollow portion 3 of the package main body portion 4 is performed, thus completing the vacuum sealed package as shown in FIG. 14.

As described in detail above, according to the vacuum sealed package P in the first exemplary embodiment of the present invention, the third conductor pad 14 is outside of the hollow portion 3 of the package main body portion 4, and is connected via the thermally conductive material 13 with the first conductor pad 11 that is formed on the wiring substrate inside of the hollow portion 3 of the package main body portion 4. After vacuuming and sealing the hollow portion 3 of the package main body portion 4, for example if the laser beam 21 is emitted onto the third conductor pad 14, the first conductor pad 11 will be heated through the thermally conductive material 13, and the getter material G on the first conductor pad 11 will be heated. Thereby, it is possible to cause gas molecules in the hollow portion 3 of the package main body portion 4 to adsorb to the getter material G, and it is possible to prevent a reduction in the level of vacuum in the hollow portion 3.

That is, since it is possible to heat via the thermally conductive material 13 the getter material G on the first conductor pad 11 in the hollow portion 3 of the package main body portion 4 after vacuuming and sealing the hollow portion 3 of the package main body portion 4 in the aforementioned vacuum sealed package P, in a package of a type that performs sealing of the package main body portion 4 in a state of the interior being vacuumed in advance, it is possible to maintain the vacuum state after sealing of the package main body portion 4 and possible to significantly improve the productivity of the package with a simple system that does not use an expensive vacuum apparatus, such as disclosed in Patent Documents 1 to 3 (a vacuum apparatus with a mechanism that moves a machine component provided therein, or a robot handling mechanism or the like provided therein).

[Exemplary Embodiment 2]

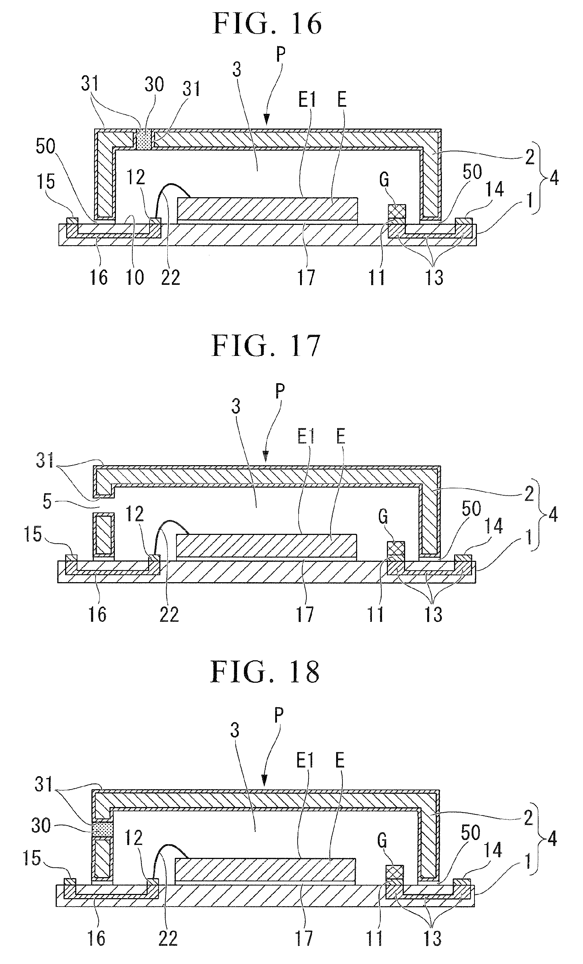

Next, a second exemplary embodiment of the present invention shall be described with reference to FIG. 15 to FIG. 25. In FIG. 15 and FIG. 16, portions that are the same as the constituent elements in FIG. 1 to FIG. 14 are denoted by the same reference symbols, and so explanations thereof are omitted. Since the basic configuration of this second exemplary embodiment is the same as the first exemplary embodiment described above, only the points of difference therebetween shall mainly be described here. Note that FIG. 15 is a cross-sectional view that shows the state prior to sealing the through-hole 5, while FIG. 16 is a cross-sectional view that shows the state after sealing the through-hole 5.

In this second exemplary embodiment, the through-hole 5 for evacuation is formed in advance in the second main body portion 2 that serves as the lid member of the package main body portion 4. The method of plugging this through-hole 5 differs from the first exemplary embodiment. The number of through-holes 5 may be one, but it is preferable that a plurality be formed in order to raise the evacuation efficiency. It is preferable to design the optimal number of through-holes 5 from the standpoint of the formation cost of the through-holes 5 and the process cost related to evacuation time.

The through-hole 5 is formed by a method such as anisotropic etching, isotropic etching, dry etching, drilling, sand blasting, ultrasonic machining, and wire-electrical discharge. In the case of the substrate in which the through-hole 5 is formed being Si, it is possible to form the through-hole 5 by anisotropic etching or isotropic etching. That is to say, the through-holes 5 may be formed such that a mask or an alkali-resistant resist that is comprised of $SiO_2$ SiN, SiON or a metallic material is formed at a portion where the through-holes 5 are not formed, and then etching is performed by KOH, TMAH (tetra methyl ammonium hydroxide), hydrazine, EPW (ethylenediamine-pyrocatechol-water), or the like. Furthermore, in the case of the substrate being a metallic material instead of Si, a photoresist may be used as the mask material, and an acid or alkali may be used as the etching liquid. The method of forming the through-holes 5 is also common among the exemplary embodiments described later.

The through-hole 5 is plugged by a sealing member 30 that consists of the material that constitutes the second main body portion 2, or a material with a lower melting point than the material that constitutes the second main body portion 2 that is formed in the vicinity of the through-hole 5 or over the entire surface of the second main body portion 2. FIG. 15 and FIG. 16 show a structure in which the low-melting-point material is formed over the entire surface of the second main body portion 2 as a representative example.

Also, although not shown in FIG. 15 and FIG. 16, the through-hole 5 may be provided in the first main body portion 1 that is integrated with the wiring substrate 10, and has a structure that is plugged by the sealing member 30 that consists of the material that constitutes the wiring substrate 10 or a low-melting point material, the melting point of which is lower than the material that constitutes the wiring substrate 10.

By using for example a laser beam apparatus to conduct local heat application on the perimeter of the through-hole 5 to a temperature equal to or above the melting point of the material, the sealing member 30 is melted and fixed in a state of blocking the through-hole 5, whereby the through-hole 5 is plugged. At this time, the location where the through-hole 5 is plugged becomes the sealing member 30. In the case of the material that constitutes the second main body portion 2 being metal or Si, generally the melting point is approximately 1000°C or higher, so by forming in advance for example Sn or an Sn-containing alloy material (Sn, SnPb, SnAg, SnAgCu, SnCu, SnIn, SnZn, SnBi, SnZnBi or the like, the melting point of which is approximately 100°C to 300°C) on the surface of the second main body portion 2 (in the vicinity of the through-hole 5, or over the entire surface of the second main body portion 2), and performing local heating of this solder material with a laser, this through-hole 5 is sealed with the solder material. This method can further reduce the power of the laser device, and can lower the manufacturing cost. This kind of solder material is formed for example by an electrolytic plating method, a nonelectrolytic plating method, a sputtering method, a vacuum deposition method, or the like. If the second main body portion 2 is an electric conductor such as metal, it is preferable to manufacture with an electrolytic plating method from the aspect of manufacturing cost. Also, since these solder materials have a high energy absorption rate for a laser beam, from the aspect of heat absorption efficiency as well it is possible to cause them to melt using a lower power laser apparatus when performing local heat application using a laser beam, and so it is possible to lower the equipment investment cost for the manufacturing installation. As a result, it is possible to shorten the laser irradiation time, and possible to lower the process cost.

The low-melting-point solder material may be formed on the entire surface of the second main body portion 2 (including the inside of the through-hole 5), and may be formed only at the periphery of the through-hole 5 and the inside of the through-hole 5. From the aspect of manufacturing cost, it is more preferable to form a film-like low-melting-point portion (denoted by reference number 31) consisting of a low-melting-point metal material on the entire surface of the second main body portion 2 since the cost of masking is eliminated and therefore this can be conducted inexpensively. That is to say, by forming the film-like low-melting-point portion 31 over the entire surface of the second main body portion 2 including the through-hole 5, the process using a mask is eliminated compared to a structure having the low-melting-point structure formed partly thereon, and so it is possible to realize an inexpensive vacuum sealed package.

As shown in FIG. 15, the low-melting-point portion 31 is formed on the entire surface of the second main body portion 2, whereby it is possible to not only make the low-melting-point portion 31 function as a material that blocks the through-hole 5, but also make it function as a material that bonds the second main body portion 2 and the wiring substrate 10. For that reason, with just a single process of forming the low-melting-point metal material, it is possible to inexpensively manufacture a vacuum sealed package compared to the case of separately forming a fixing material that bonds the second main body portion 2 and the wiring substrate 10.

Also, as shown in FIG. 15, if this low-melting-point portion 31 is formed inside the through-hole 5, the low-melting-point portion 31 that is melted by heat application also has good wet-spreading in the interior of the through-hole 5, and so there is the advantage of being able to reliably plug the through-hole 5. In the case of the low-melting-point portion 31 not being formed inside the through-hole 5, and the main material of the second main body portion 2 itself being exposed, a wetting defect with the low-melting-point portion 31 occurs, and so it takes a long time when plugging the interior of the through-hole 5.

Moreover, in the case of a structure in which the low-melting-point portion 31 is not formed on the entire surface of the second main body portion 2 or the perimeter of the through-hole 5 including the interior thereof, the size of the through-hole 5 needs to be a small size of approximately 100 $\mu$m or less in order to reliably plug the through-hole 5 (when the hole is large, plugging it is difficult). However, taking into consideration the strength of drill teeth, it is difficult to form a through-hole 5 of 100 $\mu$m or less by a machining process.

On the other hand, in the case of a structure in which the low-melting-point portion 31 is formed on the entire surface of the second main body portion 2 or the perimeter of the through-hole 5 including the interior thereof, the through-hole 5 is made to have a diameter of approximately 200 $\mu$m, which can be easily formed in a machining process, and thereafter if the low-melting-point portion 31 is formed with a thickness of 70 $\mu$m on the surface of the second main body portion 2 including the interior of the through-hole 5, it is possible to easily form a hole with a diameter of 60 $\mu$m. Further, if the hole diameter is 60 $\mu$m, it is possible to easily plug the through-hole 5 by melting the low-melting-point portion 31.

There is no particular restriction as to the dimension of the through-hole 5, but it is preferable for it to be as small as possible. The reason for this is that when the through-hole 5 is large, then the amount of time required for plugging the through-hole 5 will become long, and the power of a laser apparatus for plugging the through-holes 5 will need to be high, consequently making the manufacturing cost high. On the other hand, when the size of the through-hole is too small, the problem arises of vacuuming taking a long time, and so it is preferable to determine the size of the through-holes 5 in terms of the cost of the total process.

FIG. 15 and FIG. 16 show the example of the through-hole 5 being formed in the ceiling surface of the second main body portion 2, but it is not limited to this, and it is possible to suitably change the position of the through-hole 5. For example, as shown in FIG. 17, the through-hole 5 may be formed in the side surface of the second main body portion 2, and as shown in FIG. 18, the through-hole 5 may be plugged in a similar manner to that described above.

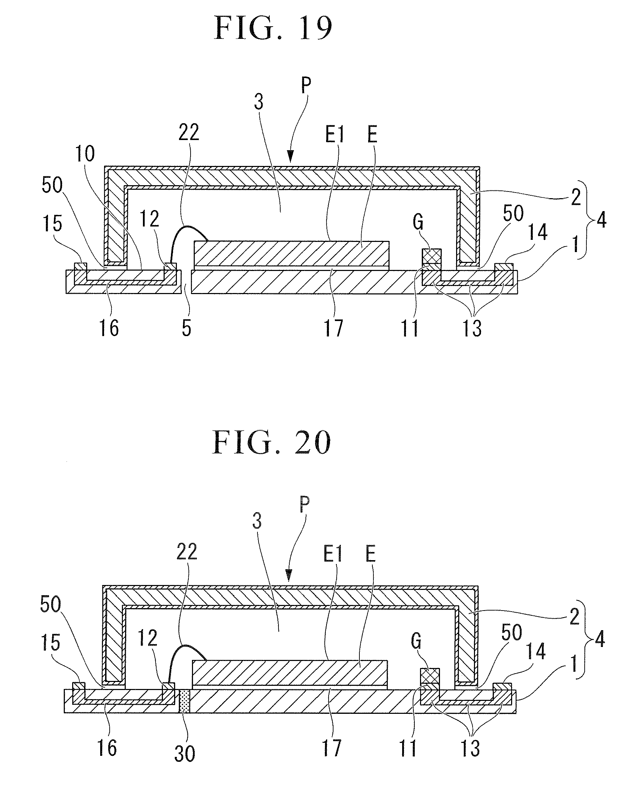

As shown in FIG. 19, the through-hole 5 may be formed in the first main body portion 1 that integrally has the wiring substrate 10, and as shown in FIG. 20, the through-hole 5 may be plugged in a similar manner to that described above. In this way, in the second exemplary embodiment of the present invention, since the hollow portion 3 of the package main body portion 4 is evacuated in the same way as the first exemplary embodiment, it is possible to seal the electronic device E in an environment in which there is almost no oxygen and water vapor, and as a result, it is possible to realize a package with superior long-term reliability and a low malfunctioning rate. Also, in the case of the electronic device E being an infrared ray sensor (infrared ray receiving element), by preserving the hollow portion 3 of the package main body portion 4 in a high vacuum state, it is possible to efficiently receive infrared radiation from outside of the package main body portion 4, and it is possible to realize a package with no degradation in performance in the long run.

Hereinbelow, the method for manufacturing the second exemplary embodiment of the present invention shall be described. The initial steps of the manufacturing process are the same as the second exemplary embodiment of the present invention, and so shall be omitted. The description shall commence from the step of performing evacuation.

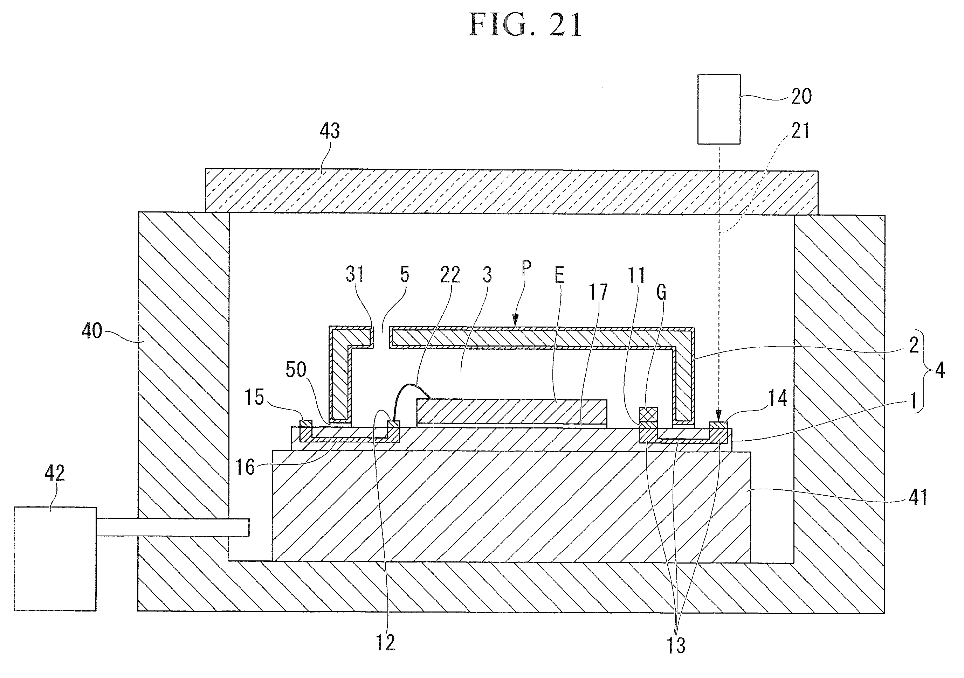

In the state prior to plugging the through-hole 5 as shown in FIG. 21, that is, the state in which the electronic device E and the getter material G are mounted in the hollow portion 3, and the second main body portion 2 and the wiring substrate 10 are bonded, the package main body portion 4 prior to vacuum sealing is placed on a stage 41 inside a vacuum chamber 40. Next, in addition to vacuuming the interior of the vacuum chamber 40 with a vacuum pump 42, the interior of the hollow portion 3 of the package main body portion 4 is vacuumed through the through-hole 5. While performing the vacuuming, the stage 41 and the entire chamber are heated to 100°C or higher (the temperature of the boiling point of water or higher), whereby water content in the interior of the vacuum chamber 40 and the interior of the package main body portion 4 is removed.

Next, as shown in FIG. 21, using a laser apparatus 20 that is installed on the outside of the vacuum chamber 40, the laser beam 21 is transmitted through a glass transmissive window 43 that is installed on the upper portion of the vacuum chamber 40, and emitted on the third electrode pad 14. Thereby, the third electrode pad 14 is heated, and the heat of the laser beam 21 is transmitted to the first conductor pad 11 via the thermally conductive material 13 that is connected with the third electrode pad. The getter material G that is mounted or formed on the first conductor pad 11 is indirectly heated and activated. That is, the molecules adsorbed to the surface of the getter material G are discharged.

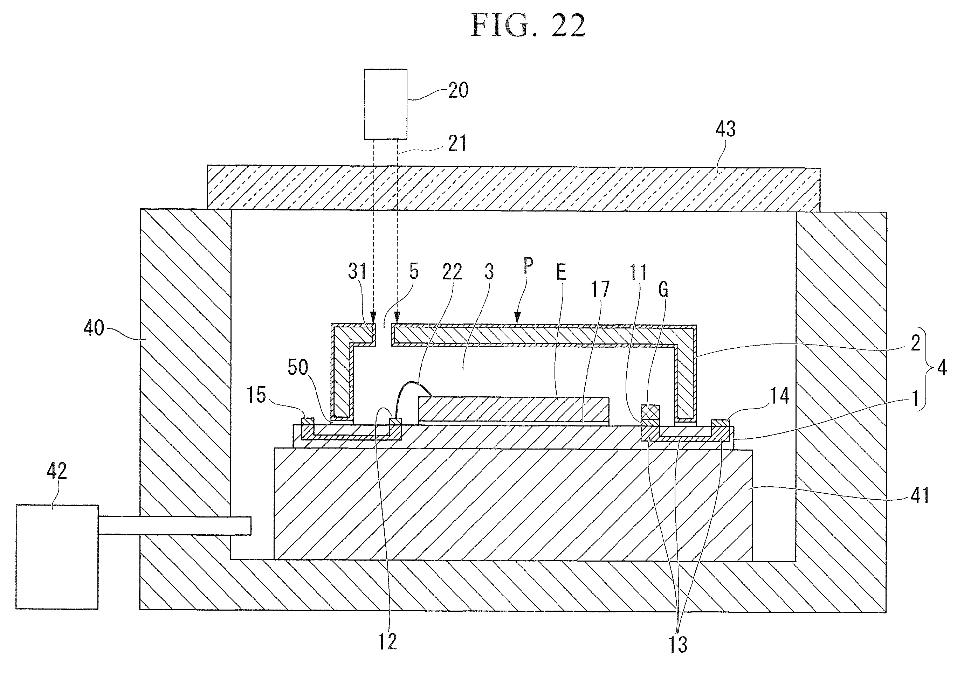

Subsequently, as shown in FIG. 22 the position of the laser apparatus 20 that is installed on the outside of the vacuum chamber 40 is moved, and the laser beam 21 is transmitted through the glass transmissive window 43 that is installed in the vacuum chamber 40, and emitted on the perimeter of the through-hole 5 of the package body portion 4. Thereby, local heating is performed only at the perimeter of the through-hole 5, and the material that constitutes the second main body portion 2 is heated to the temperature of the melting point or higher, and by melting the material the through-hole 5 is plugged. In this way, the vacuum sealed package shown in FIG. 16 is manufactured.

The method of emitting the laser beam 21 to heat only the third conductor pad 14, and the method of heating only the perimeter of the through-hole 5 do not expose the electronic device E to a high temperature, and so do not degrade the characteristics of the electronic device E. Moreover, since the locations where the second main body portion 2 and the wiring substrate 10 are bonded and the locations where the electronic device E and the wiring substrate 10 are bonded are not made to exfoliate by the heat, there are significant advantages in terms of manufacturing.

Also, since it is possible to emit the laser beam 21 on the perimeter of the through-hole 5 (prior to plugging the through-hole 5) of the package installed in the vacuum chamber 40, even if the laser device is not arranged in a vacuum, it is possible to realize a more compact vacuum chamber 40, and it is possible to achieve a more inexpensive vacuum chamber 40. As a result, it is possible to manufacture a vacuum sealed package at a more inexpensive manufacturing cost.

Furthermore, although there is no particular restriction, the diameter of the laser beam 21 is preferably greater than the diameter of the through-hole 5. If the diameter of the laser beam 21 is smaller than the diameter of the through-hole 5, then there will be employed a method in which the laser beam 21 is irradiated so as to serially trace the outer periphery of the through-hole 5 to gradually plug the through-hole 5. Consequently, in this method the time required for plugging the through-hole 5 becomes longer, and so there is a tendency for the manufacturing process cost to increase.

On the other hand, if the diameter of a laser beam 21 is greater than that of the through-hole 5, the center of the spot diameter of the laser beam 21 can be made to align with the center of the through-hole 5. Thereby, it is possible to shorten the time of plugging the through-hole 5 since it is possible to emit the laser beam 21 on the perimeter of the through-hole 5 in one stroke, without the need to emit the laser beam 21 serially on the outer periphery of the through-hole 5.

In the case of emitting the laser beam 21 with the center of the spot diameter of the laser beam 21 aligned with the center of the through-hole 5, since the laser beam 21 passes through the center of the through-hole 5, the position of the through-hole 5 needs to be designed in advance so that the laser beam 21 does not come into contact with the electronic device E, the wire 22, the wiring, and so forth.

A YAG laser is suitable as the laser, however in addition to this another type of laser may be used provided it has the capability of melting the material to be melted, such as a ruby laser, an excimer laser, a carbon dioxide gas laser, a liquid laser, a semiconductor laser, and a free electron laser. The requirements of the laser are the same for all the exemplary embodiments of the present specification.

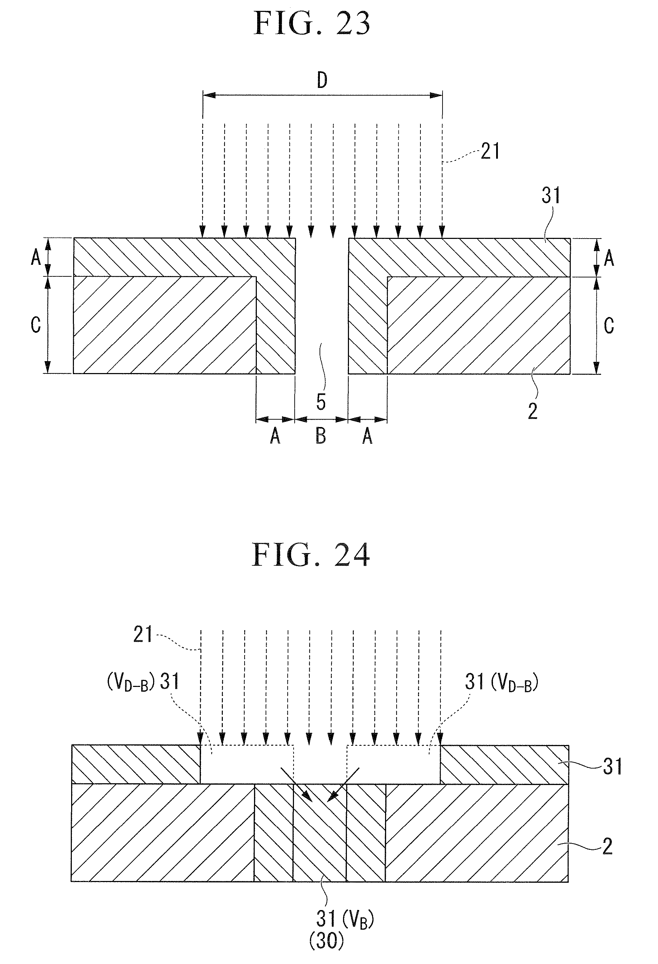

Furthermore, in the case of the exemplary embodiment of the present invention, as shown in FIG. 23, it is preferable that dimensions A, B, C, and D are defined as dimensions which satisfy the following inequations, where A is taken as the thickness of the low-melting-point portion 31 is A, B is taken as the diameter of the through-hole 5 after formation of the low-melting-point portion 31, C is taken as the thickness of the second main body portion 2 or the wiring substrate 10 in which the through-hole 5 has been formed, and D is taken as the spot diameter of the laser beam 21.

$$CB^2/(D^2 - B^2) \le A$$

$$B < D$$

The above inequations shall be described in detail below with reference to FIG. 23 and FIG. 24. FIG. 23 is a cross-sectional view showing the state of emitting the laser beam 21 on the low-melting-point portion 31 that is formed on the surface of the second main body portion 2 or the wiring substrate. FIG. 24 is a cross-sectional view showing the state in which the low-melting-point portion 31 heated by the laser beam 21 is plugging the through-hole 5.

A, B, C, and D are respectively the thickness of the low-melting-point portion 31, the diameter of the through-hole 5 after formation of the low-melting-point portion 31, the thickness of the second main body portion 2 or the wiring substrate 10 having the through-hole 5 formed therein, and the spot diameter of the laser beam 21.

Assuming that the portion where the laser beam 21 and the low-melting-point portion 31 make contact with each other is a circle with a diameter D, the following formula (1) denotes a volume 31 ($V_{D-B}$) of the low-melting-point portion 31 that is irradiated by the laser beam 21, heated to a temperature greater than or equal to the melting point, and is melted to plug the through-hole 5.

$$V_{D-B} = \pi A(D^2 - B^2)/4 \qquad (1)$$

Moreover, the following formula (2) denotes a volume 32 ($V_B$) of the through-hole 5 that is plugged by the low-melting-point portion 31.

$$V_B = \pi CB^2/4 \qquad (2)$$

Here, in order to completely fill the through-hole 5 with the low-melting-point portion 31, the following formula (3) needs to be satisfied.

$$V_B \leq V_{D\text{-}B} \qquad (3)$$

For that reason, by substituting formulas (1) and (2) for the values of the formula (3) and rearranging yields the following formula (4).

$$CB^2 / (D^2 - B^2) \leq A \qquad (4)$$

Since the spot diameter D of the laser beam 21 needs to be greater than the diameter B of the through-hole 5 in order to heat the low-melting portion 31 on the periphery of the through hole 5, it is necessary to satisfy the condition denoted by the following formula (5).

$$B < D \qquad (5)$$

That is to say, the thickness A of the low-melting portion 31 is set so that the volume ($V_{D\text{-}B}$) of the low-melting portion 31 to be melted may become greater than the volume ($V_B$) of the through-hole 5, and the spot diameter D of the laser beam 21 is set so as to be greater than the diameter B of the through-hole 5.

As described above, by preliminarily designing the thickness A of the low-melting portion 31, the diameter B of the through-hole 5 after the low-melting portion 31 has been formed, the thickness C of the second main body portion 2 or the wiring substrate 10 having the through-hole 5 formed therein, and the spot diameter D of the laser beam 21 so as to satisfy the formulas (4) and (5), it is possible to reliably plug the through-hole 5 with the low-melting portion 31, and it is possible to realize a package with a high manufacturing yield.

Moreover, the above-mentioned method is a method that can best shorten the emission time of the laser beam 21, and plug the through-hole 5. However, in the case of wanting to manufacture a package using existing equipment, but there being no equipment specification that can satisfy formula (5), such that the spot diameter D of the laser beam 21 is smaller than the diameter B of the through-hole 5 (B > D), it is possible to emit the laser beam 21 so as to draw a circle along the periphery of the entrance opening of the through-hole 5, and plug the though-hole 5. In this method, the shot number of the laser beam 21 increases in order to draw a circle, and so the time for plugging the through-hole 5 becomes longer than the aforementioned method.

Moreover, according to the vacuum sealed package in this exemplary embodiment, since the through-hole 5 is plugged by directly melting the constituent material at the through-hole 5 perimeter by conducting local heat application such as laser beam irradiation, it is possible to eliminate the process of placing on the through-hole 5 a third fixing material for plugging the through-hole 5, and possible to cut the manufacturing cost.

In the first exemplary embodiment of the present invention shown in FIG. 1 to FIG. 14 and the second exemplary embodiment of the present invention shown in FIG. 15 to FIG. 22 described hitherto, various types of electronic devices E were assumed, but for example in the case of the electronic device E being an infrared ray receiving element (infrared ray sensor) 44, an infrared ray transmissive window 45 is provided in the second main body portion 2.

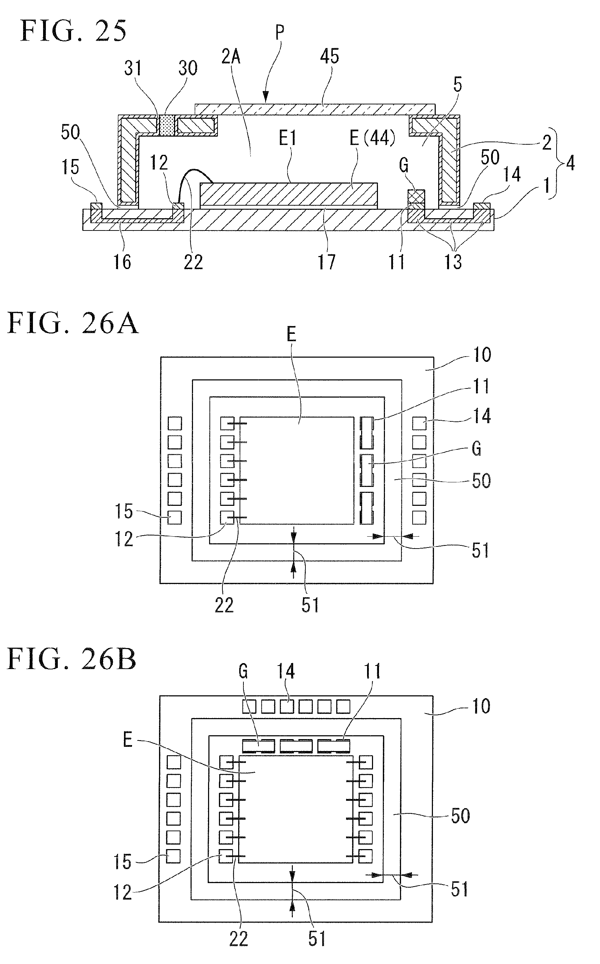

For example, FIG. 25 shows a structure that is a modification of the second exemplary embodiment of the present invention, in which a large through-hole 5 that differs from the evacuation hole that is provided in advance in the second main body portion 2 (a hole of nearly the same size as the size of the infrared ray receiving element 44 or the light receiving portion of the infrared ray receiving element 44, and hereinbelow called an opening portion 2A) is provided, and an infrared ray transmissive window 45 is bonded so as to block the through-hole 5.

Here, the infrared ray receiving element 44 which is an infrared ray sensor shall be explained in detail. There are two types of infrared ray receiving elements 44, namely, "quantum type" and "thermal type". Since the "thermal type" has a simpler structure and the manufacturing cost is lower, it is preferable to use a thermal-type infrared ray receiving element 44 from the point of manufacturing cost. Moreover, in order to increase the sensitivity of the thermal-type infrared ray receiving element 44, it is necessary to increase the thermal insulation property in order to enlarge temperature changes in the infrared detecting element by ensuring that the heat generated in the infrared detecting element is retained as much as possible when infrared radiation is emitted on the infrared ray receiving element 44. Consequently, in order for the thermal-type infrared ray receiving element 44 to exhibit the minimum performance, generally a vacuum state of $10^{-2}$ Torr or lower is required as a surrounding environment. That is to say, a vacuum environment in which there are almost no gas molecules inside the package main body portion 4 is needed. Also, in order to maintain the stability of the device over a prolonged period of time, it is additionally preferable to further increase the level of vacuum immediately after vacuum sealing. Further, it is preferable that the through-hole 5 be sealed with a high degree of airtightness after evacuating the inside of the package main body portion 4 preferably to $10^{-6}$ Torr or less. Even if referred to as vacuum sealing, it is nevertheless highly unlikely for the level of vacuum of the inside not do drop after sealing, and so it always has a leak rate that is a finite value. The higher the level of vacuum just after vacuum sealing, the longer the time required for the level of vacuum to deteriorate to $10^{-2}$ Torr at which minimum performance can be still exhibited even at the same leak rate, and so ultimately it is possible to realize a package in which an infrared ray receiving element 44 having a high level of long-term reliability is mounted.

In the vacuum sealed package in the present exemplary embodiment that includes the infrared ray receiving element 44, a rectangular opening 2A is provided at a portion positioned directly above (a portion opposed to) the light receiving portion of the infrared ray receiving element 44 of the second main body portion 2, and an infrared ray transmissive window 45 that is comprised of an infrared ray transmissive window material (a material that allows infrared radiation to pass) is bonded so as to block that infrared ray transmissive hole 35.

Although the infrared ray receiving element 44 is mounted in the package body portion 4 that has been vacuum sealed, since infrared rays need to be transmitted from the outside of the package into the package main body portion 4, as the material of the infrared ray transmissive window 45, in addition to Si, Ge, ZnS, ZnSe, $Al_2O_3$, $SiO_2$ or the like, materials including an alkali halide-based material or alkali earth halide-based material such as LiF, NaCl, KBr, CsI, $CaF_2$, $BaF_2$, $MgF_2$ or the like, and a chalcogenide-based glass that has Ge, As, Se, Te, Sb or the like as the main component thereof, are preferable in order to be able to transmit infrared rays.

According to this constitution, the infrared ray receiving element 44 is sealed within a vacuum, and the infrared ray transmissive window 45 is mounted at a position directly above the light receiving portion of the infrared ray receiving element 44. Therefore, the infrared radiation passes from the outside of the sealed package through the infrared ray transmissive window 45, and it reaches the light receiving portion of the infrared ray receiving element 44. For that reason, it is possible to realize an infrared ray sensor package with a high level of sensitivity. Also, although not illustrated in the present exemplary embodiment, an antireflection film is formed in advance on the surface of the infrared ray transmissive window 45. Furthermore, while Torr is used as the unit of pressure in the present specification, it is possible to convert it to an SI unit at 1 Torr = 133.3 Pa.

According to the vacuum sealed package P in the second exemplary embodiment of the present invention as described in detail above, after evacuating and sealing the inside of the hollow portion 3 of the package main body portion 4, by heating the getter material G via the thermally conductive material 13 that couples the first and third conductor pads 14 that are respectively inside and outside of the hollow portion 3 of the package body portion 4, it is possible to maintain the vacuum state inside the hollow portion 3 of the package body portion 4. Therefore, in a package of a type that performs sealing of the package main body portion 4 in the state of the interior being vacuumed in advance, it is possible to maintain the vacuum state after sealing of the package main body portion 4 with a simple system that does not use an expensive vacuum apparatus such as disclosed in Patent Documents 1 to 3 (one with a movable machine component provided therein, or a robot handling mechanism or the like provided therein), and so it is possible to significantly improve the productivity of the package.

In the vacuum sealed package P in the second exemplary embodiment, the sealing member 30 that seals the through-hole 5 to the inside of the hollow portion 3 of the package body portion 4 and the outside is constituted by partially heating the vicinity of the through-hole 5 such that a constituent material of the package main body portion 4 is melted. Therefore, by for example making the sealing member 30 a low-melting point material with melting point lower than the package main body portion 4, it is possible to perform sealing of the through-hole 5 with a low-power laser device, and as a result it is possible to lower the manufacturing cost.

In the present exemplary embodiment, the low-melting-point portion 31, which is comprised of a low-melting point metal material having a lower melting point than the package main body portion 4, is provided in the vicinity of the through-hole 5, and the low-melting-point portion 31 is heated and melted, thereby forming a portion or all of the sealing member 30 that plugs the through-hole 5.

In a conventional structure in which the main material itself of the package main body portion 4 is exposed without a film of a low-melting-point metal on the interior of the through-hole 5, time is required for plugging the interior of the through-hole 5 due to the occurrence of a wetting defect. In contrast, in the present exemplary embodiment, by heating the low-melting-point portion 31, the low-melting-point portion 31 has good wet-spreading also in the interior of the through-hole 5, and so there is the advantage of being able to reliably plug the through-hole 5. That is to say, in a package of a type that performs sealing of the package main body portion 4 in the state of the interior being evacuated in advance, it is possible to perform sealing of the package main body portion 4 with a simple system, and possible to significantly improve the productivity thereof.

[Exemplary Embodiment 3]

Next, a third exemplary embodiment shall be described with reference to FIG. 26A to FIG. 28. In these figures, the same reference symbols are given to those portions that are the same as the constituent elements in the preceding FIG. 1 to FIG. 25, and descriptions thereof are omitted. Hereinbelow, only the points of difference with the aforementioned exemplary embodiments shall be described. Note that FIG. 26A of the third exemplary embodiment is an example of the first conductor pad 11 and the second conductor pad 12 being provided at opposing positions sandwiching the electronic device E, and FIG. 26B is an example of the first conductor pad 11 and the second conductor pad 12 being provided at positions adjacent to the side positions of the electronic device E.

A width 51 of a conductor pattern 50 that surrounds the periphery of an electronic device E that is formed on the wiring substrate 10, which is a characteristic of the third exemplary embodiment of the present invention, shall be described.

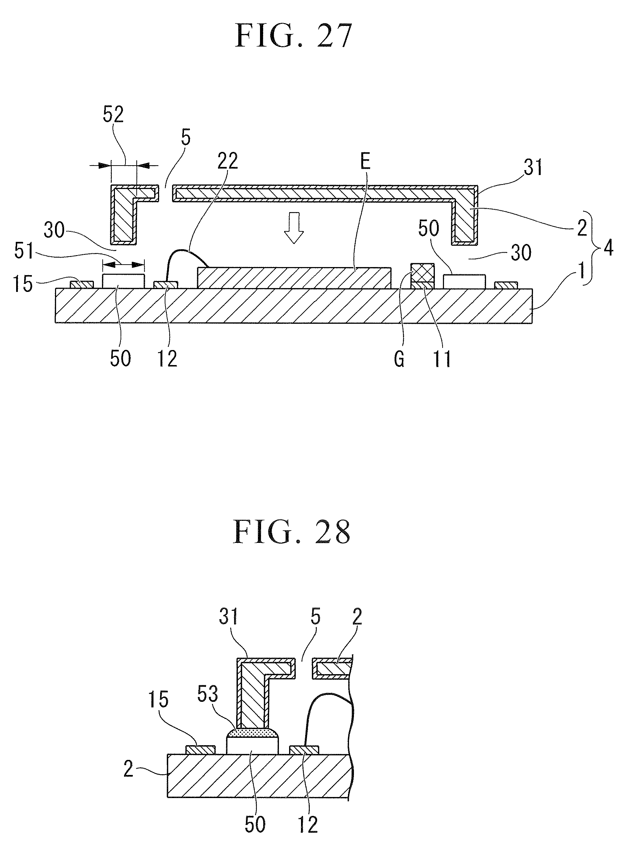

In the case of using the wiring substrate 10 in the first main body portion 1 of the package as with the first exemplary embodiment and the second exemplary embodiment of the present invention, a continuous conductor pattern 50 is formed that surrounds the periphery of the electronic device E on the surface of the wiring substrate 10. As shown in FIG. 27 and FIG. 28 that correspond to FIG. 26A, a width 51 of this conductor pattern is greater than the bonding width 52 of the second main body portion 2 to be bonded with the wiring substrate 10.

By using this kind of structure, the continuous conductor pattern 50 that is formed on the surface of the wiring substrate 10 so as to surround the periphery of the electronic device E and the second main body portion 2 are bonded, with the width 51 of the conductor pattern 50 wider than the bonding width 52 of the second main body portion 2. Accordingly, it is possible to sufficiently cover the periphery of the second main body portion 2 via a bonding portion 53 that is formed by a bonding material that bonds the second main body portion 2 and the wiring substrate 10 (for example, a low-melting-point metal film), and it is possible to realize a package with a higher level or reliability.

Although not shown in FIG. 26A to FIG. 28, it is preferable that Au be formed on the surface of the conductor pattern 50 that is formed on the wiring substrate 10 and on the surface of the conductor pads 11, 12, 14 and 15, or on either one of these surfaces.

In the vacuum sealed package P, after sealing the package main body portion 4, it is necessary to avoid the occurrence of outgassing, which can invite a drop in the long-term reliability of the electronic device E and cause degradation of the performance due to a drop in the vacuum. For that reason, the bonding of the second main body portion 2 and the circuit substrate 13 is preferably performed by a process that does not employ flux. In a process that does not use flux, oxidation of the bonding portion section impedes airtight bonding. Therefore, in order to prevent such oxidization, it is preferable that Au be formed in advance on at least any one surface of the surface of the conductor pattern 50 and the surfaces of the conductor pads 11, 12, 14, and 15.

According to this constitution, it is possible to prevent oxidation of the surface of the conductor pattern 50 and the conductor pads 11, 12, 14 and 15, and it is possible to achieve a superior solder wettability. Also, there is the advantage of being able to perform wire bonding using a wire that has a metal such as Au or Al as the main component, and it is possible to achieve a package with a high manufacturing yield and a high design flexibility.

[Exemplary Embodiment 4]

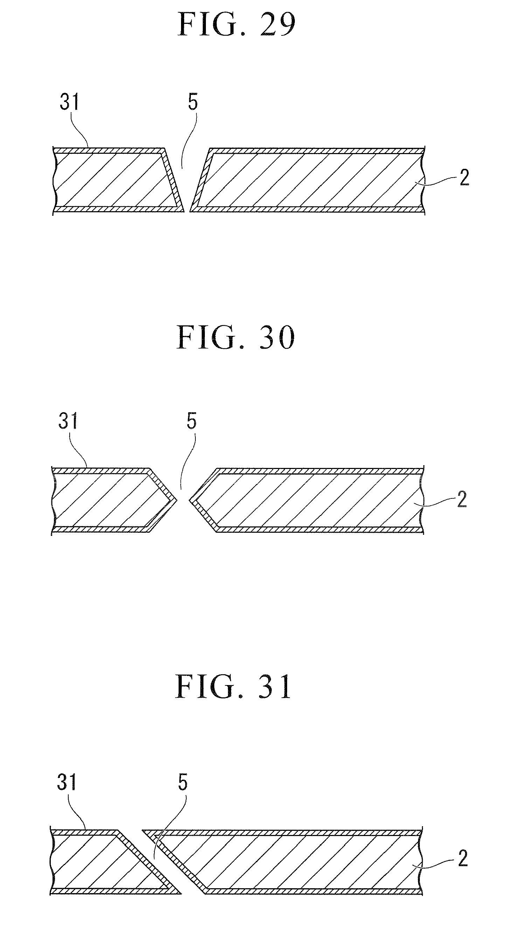

Next, a fourth exemplary embodiment of the present invention shall be described with reference to FIG. 29 to FIG. 31. In these FIG. 29 to FIG. 31, those locations corresponding to constituent elements disclosed in FIG. 1 to FIG. 28 shall be denoted by the same reference symbols, and descriptions thereof shall be omitted. Hereinbelow, those points of difference with the forgoing exemplary embodiments shall be described.

The through-hole 5 in the fourth exemplary embodiment is formed with a tapered shape so that the hole diameter gradually becomes smaller from the outermost surface of one surface of the second main body portion 2 or the wiring substrate 10 to the surface on the opposite side.

When the diameter of the through-hole 5 is formed with a tapered shape such that the hole diameter gradually becomes smaller from the outermost surface of one surface of the second main body portion 2 or the wiring substrate 10 to the surface on the opposite side, it is possible to directly emit the laser beam 21 not only on the outermost surface of one surface of the second main body portion 2 or the wiring substrate 10 (the place where the hole diameter is greatest), but also on the surface of the interior of the through-hole 5. For that reason, since the material on the interior of the through-hole 5 is also heated and can be melted. As a result, it is possible to more easily plug the through-hole 5, and it is possible to achieve a package with a high manufacturing yield.

One of the methods of forming the through-hole 5 having such a tapered shape is an etching method. In particular, when anisotropic etching is used, it is possible to obtain the through-hole 5 having various types of tapered shapes. The shape of the through-hole 5 may be appropriately changed.

For example, as shown in FIG. 30, the through-hole 5 may be formed in a tapered shape in which the hole diameter gradually decreases from the outermost surface of both the surfaces of the second main body portion 2 or the wiring substrate 10 toward the center in the depth direction of the hole. When the through-hole 5 is formed in this kind of shape, there is the advantage in that not only is the same effect to that of the through-hole 5 shown in FIG. 29 obtained, but even in the case of the thickness of the second main body portion 2 or the wiring substrate 10 in which the through-hole 5 is formed being thicker, the through-hole 5 can be easily formed eventually (as the thickness increases, the through-hole 5 cannot be formed in a tapered shape). That is, in the case of the interior of the through-hole 5 having a tapered shape, the diameter gradually becomes smaller heading in the depth direction of the hole, but for the convenience of the overall design of the package or manufacturing costs, there are times when the thickness of the second main body portion 2 or the wiring substrate 10 may need to be made thicker. In such a case, instances will arise in which the through-hole cannot be formed eventually, however, this can be remedied as it is formed in a tapered shape in which the hole diameter gradually becomes smaller from both outermost surfaces of the structure toward the center in the thickness direction of the hole.

As shown in FIG. 31, the through-hole 5 may be obliquely formed with respect to the thickness direction of the second main body portion 2 or the wiring substrate 10. When the through-hole 5 is formed with such a shape, it is possible to remedy the problem in which, when the surface of the through-hole 5 and the interior surface of the through-hole 5 are heated to cause the material to melt, prior to the melted material plugging the through-hole 5, it is released to the outside of the hole due to gravity. For that reason, it is possible to realize a hole-sealing with a higher manufacturing yield. Note that the aforementioned problem has a higher probability of occurring as the size of the through-hole increases.

In FIG. 29 to FIG. 31, examples are given of the low-melting-point portion 31 having been formed on the surface of the second main body portion 2 or the wiring substrate 10. However, the inner shape of these through-holes 5 is not limited to only these examples, and it may be applied for example to a case in which the low-melting-point portion 31 is not formed, or to other exemplary embodiments.

[Exemplary Embodiment 5]

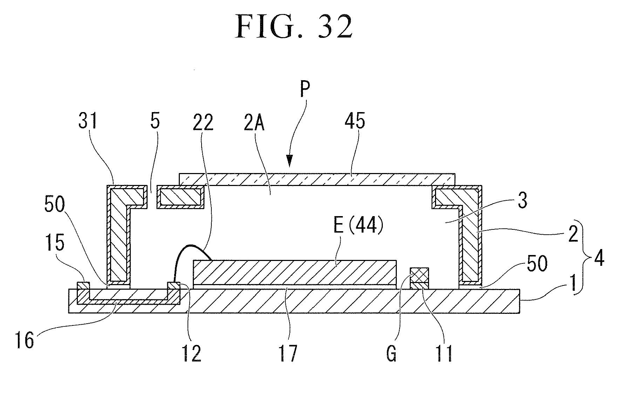

Next, a fifth exemplary embodiment of the present invention shall be described with reference to FIG. 32 to FIG. 34. In FIG. 32 to FIG. 34, portions corresponding to the constituent elements in FIG. 1 to FIG. 31 are denoted by the same reference symbols, and so explanations thereof are omitted. Hereinbelow, the points of difference with the aforementioned exemplary embodiments shall be described. FIG. 32 shows the state prior to plugging the through-hole 5 for evacuation.

As shown in FIG. 32, the vacuum sealed package P of the fifth exemplary embodiment of the present invention includes a package main body portion 4 having a vacuum hollow portion that is constituted by the first main body portion 1 and the second main body portion 2 that includes the infrared ray transmissive window 45 being joined via the hollow portion 3, the electronic device E (including the infrared ray receiving element 44) that is provided inside the hollow portion 3 of the package main body portion 4, and the getter material G.

The through-hole 5 for evacuation, which brings the hollow portion 3 and the outside of the package main body portion 4 into communication, is formed in the package main body portion 4, and the inside of the hollow portion 3 is vacuumed via the through-hole 5, and the sealing member 30 that is plugged by the low-melting-point portion 31 with the vacuum state maintained is provided in the through-hole 5 (a figure showing the sealed state is omitted).

It is preferable that the first main body portion 1 be a wiring substrate, for example. The getter material G and the electronic device E (including the infrared ray receiving element 44) are within the hollow portion 3 and respectively connected to the first conductor pad 11 and the second conductor pad 12 that are formed on the wiring substrate 10. The second conductor pad 12 is electrically connected with the fourth conductor pad 15 that is positioned on the outside of the hollow portion 3 of the package main body portion 4 and formed on the wiring substrate 10.

The getter material G is mounted on a position where contact is possible with the laser beam 21 that is emitted from outside of the package main body portion 4, passes through the infrared ray transmissive window 45, and reaches the inside of the hollow portion 3.

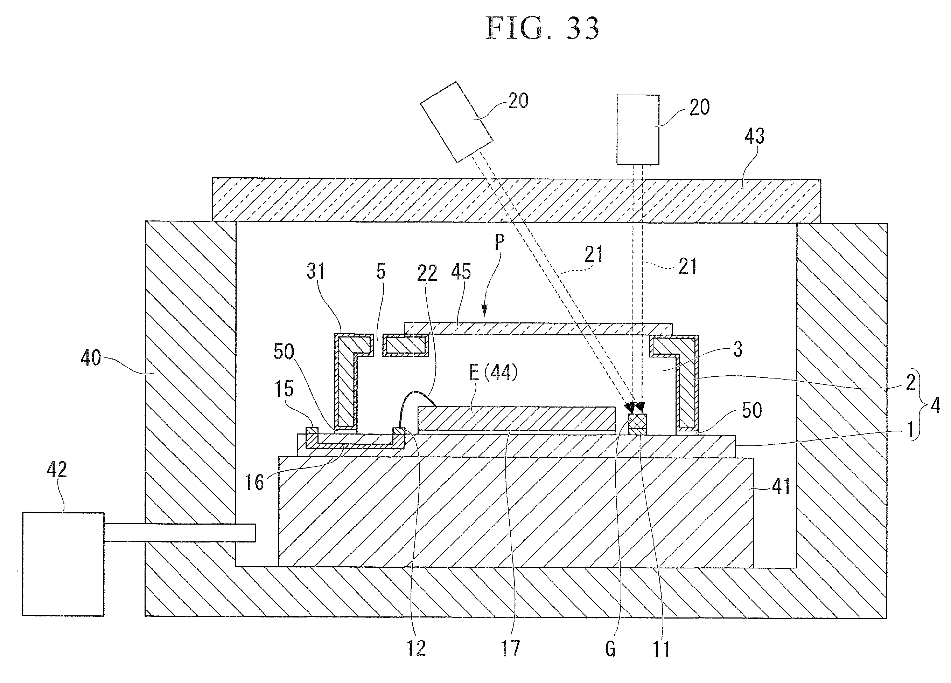

As shown in FIG. 33, the vacuum sealed package prior to plugging this kind of through-hole 5 is placed on the stage 41 of the vacuum chamber 40, and vacuum evacuation of the inside of the vacuum chamber 40 is performed. Thereby, the interior of the hollow portion 3 of the package main body portion 4 is vacuumed through the through-hole 5. At this time, the laser beam 21 is emitted from outside of the vacuum chamber 40 through the glass transmissive window 43 and the infrared ray transmissive window 45 onto the getter material G that is mounted or formed on the first conductor pad 11 in the hollow portion 3, whereby the getter material G is heated and activated. As shown in FIG. 33, the laser apparatus 20 may be mounted directly above the getter material G, or it may emit from an oblique direction through the infrared ray transmissive window 45, as shown in FIG. 33.

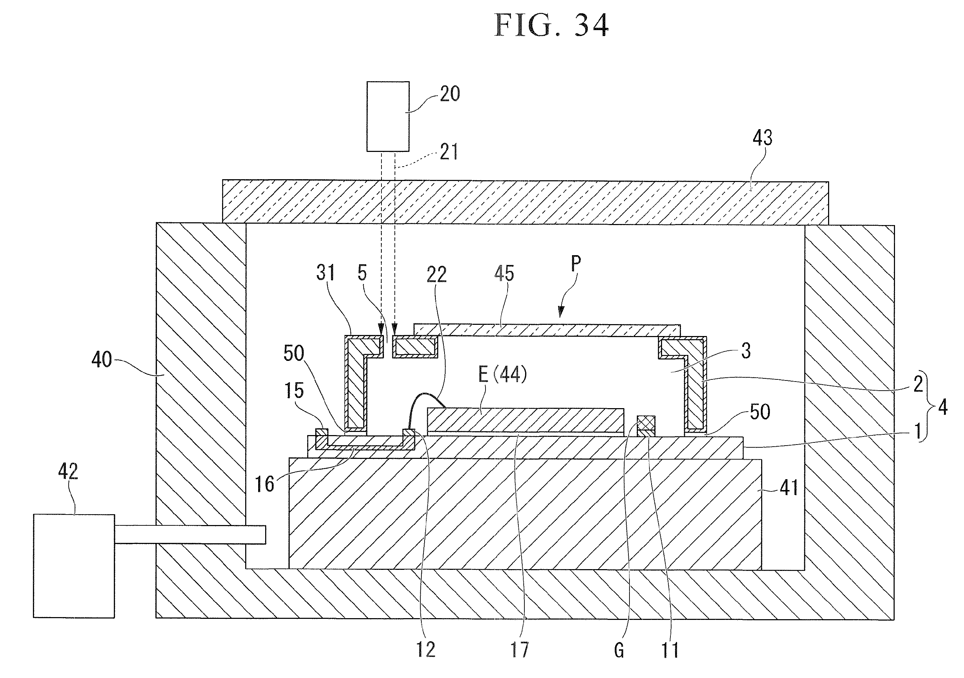

In this way, while performing vacuum evacuation, after the getter material G is heated and activated, the laser beam 21 is emitted from the outside of the vacuum chamber 40 through the infrared ray transmissive window 45 onto the low-melting-point portion 31 that is formed on the surface around the through-hole 5 as shown in FIG. 34. Thereby, the through-hole 5 is plugged by the low-melting-point portion 31, and the vacuum sealed package P of the fifth exemplary embodiment of the present invention is completed (a figure showing the appearance after plugging the through-hole 5 is omitted).

FIG. 32 to FIG. 35 depict examples in which the low-melting-point portion 31 is formed on the surface of the second main body portion 2, but the low-melting-point portion 31 is not always essential, and a method may be adopted that, by raising the power of the laser beam 21, heats the periphery of the through-hole 5 to at least the melting point of the metal material that constitutes the second main body portion 2 and plugs the through-hole 5 with the constituent material of the second main body portion 2. This is also the case for all the other exemplary embodiments of the present specification, and the through-hole 5 may be plugged with the metal material that constitutes the second main body portion 2.

[Exemplary Embodiment 6]

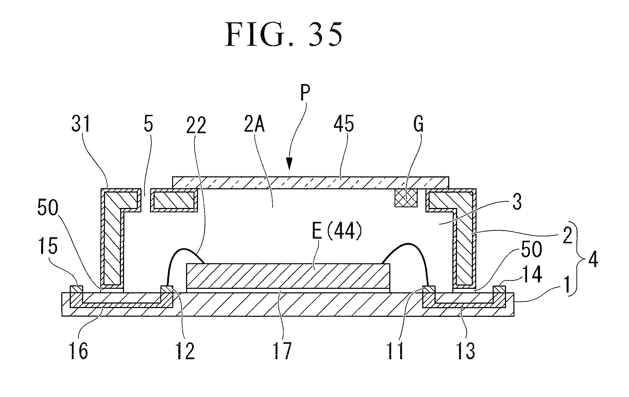

Next, a sixth exemplary embodiment of the present invention shall be described with reference to FIG. 35 to FIG. 40. In FIG. 35 to FIG. 40, portions corresponding to the constituent elements in FIG. 1 to FIG. 34 are denoted by the same reference symbols, and so explanations thereof are omitted. Hereinbelow, the points of difference with the aforementioned exemplary embodiments shall be described. FIG. 35 shows the state prior to plugging the through-hole 5 for evacuation.

The sixth exemplary embodiment differs from the fifth exemplary embodiment on the point of the getter material G being mounted or formed within the hollow portion 3 of the package main body portion 4 and on the inner surface of the infrared ray transmissive window 45. There are no particular limitations on the mounting method or formation method of the getter material G. However, it is preferable for it to be welded to the surface of the infrared ray transmissive window 45 that is comprised for example of Ge or Si and the like, or be film-formed on the surface of the infrared ray transmissive window 45 using a thin-film formation technique such as a sputtering method or a vapor deposition method.

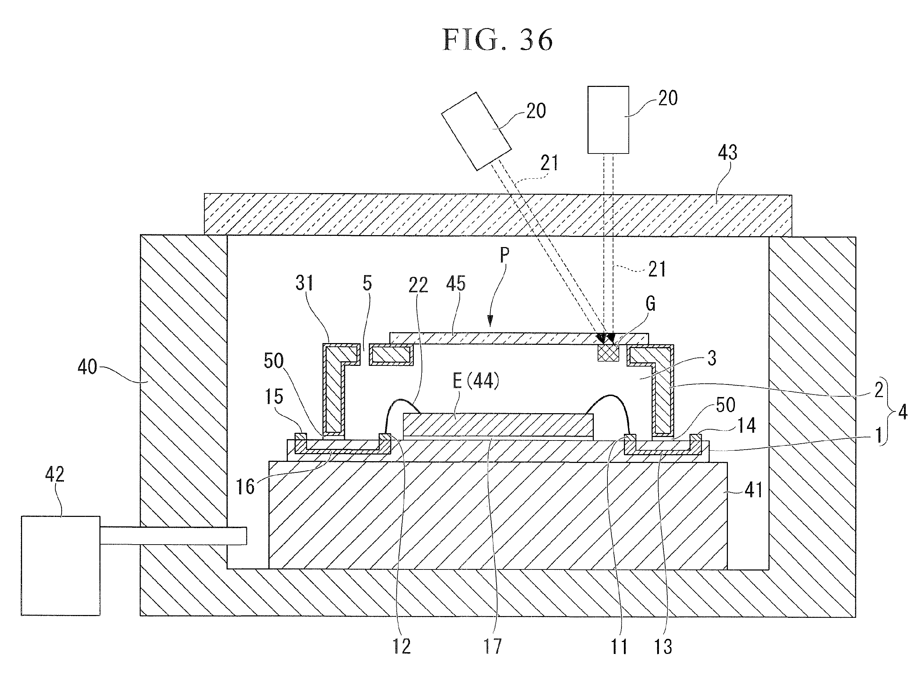

In this sixth exemplary embodiment, as shown in FIG. 36, prior to plugging the through-hole 5 for vacuum evacuation, it is placed on the stage 41 inside the vacuum chamber 40, and the inside of the vacuum chamber 40 is vacuumed to thereby evacuate, through the through-hole 5, the inside of the hollow portion 3 of the package main body portion 4. At this time, the laser beam 21 is emitted from outside of the vacuum chamber 40 through the glass transmissive window 43 and the infrared ray transmissive window 45 onto the getter material G that has been mounted or formed on the surface of the infrared ray transmissive window 45, whereby the getter material G is heated and activated. At this time, the emission position of the laser beam 21 may be such that the laser is emitted from directly above the getter material G, or emitted from an obliquely upper direction as shown in FIG. 36.

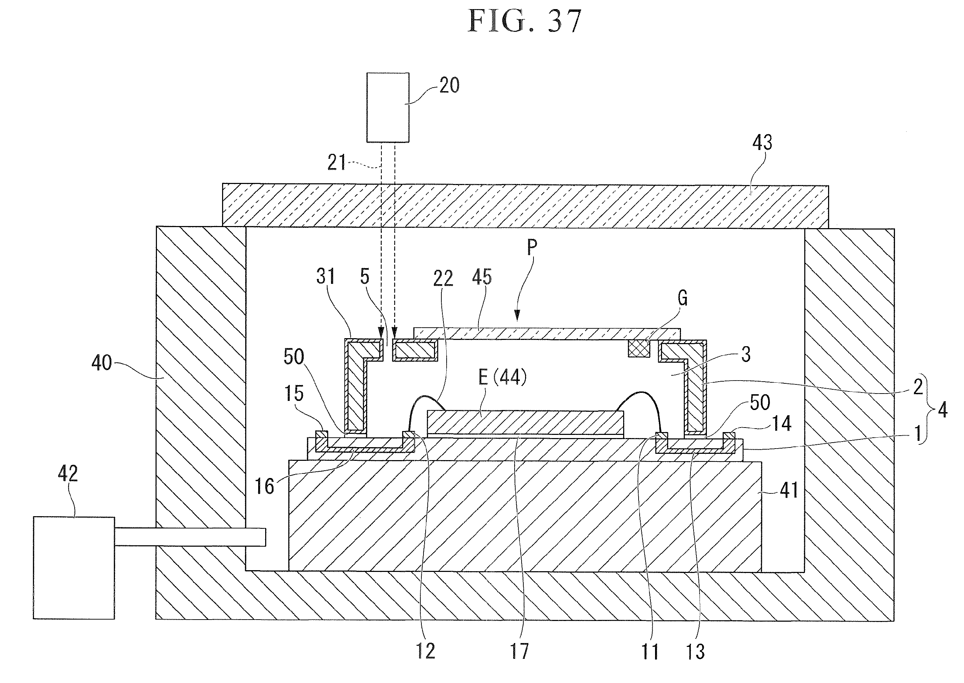

In this way, while performing vacuum evacuation, after the getter material G is heated and activated, the laser beam 21 is emitted from the outside of the vacuum chamber 40 through the infrared ray transmissive window 45 onto the low-melting-point portion 31 that has been formed on the surface of the second main body portion 2 around the through-hole 5 as shown in FIG. 37. Thereby, the through-hole 5 is plugged by the low-melting-point portion 31, and the vacuum sealed package P is completed (a figure showing the appearance after plugging the through-hole 5 is omitted).

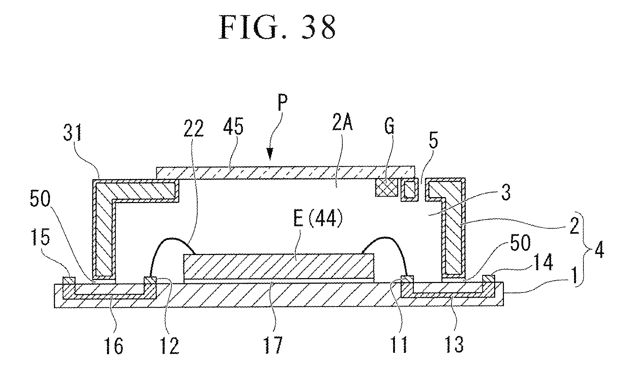

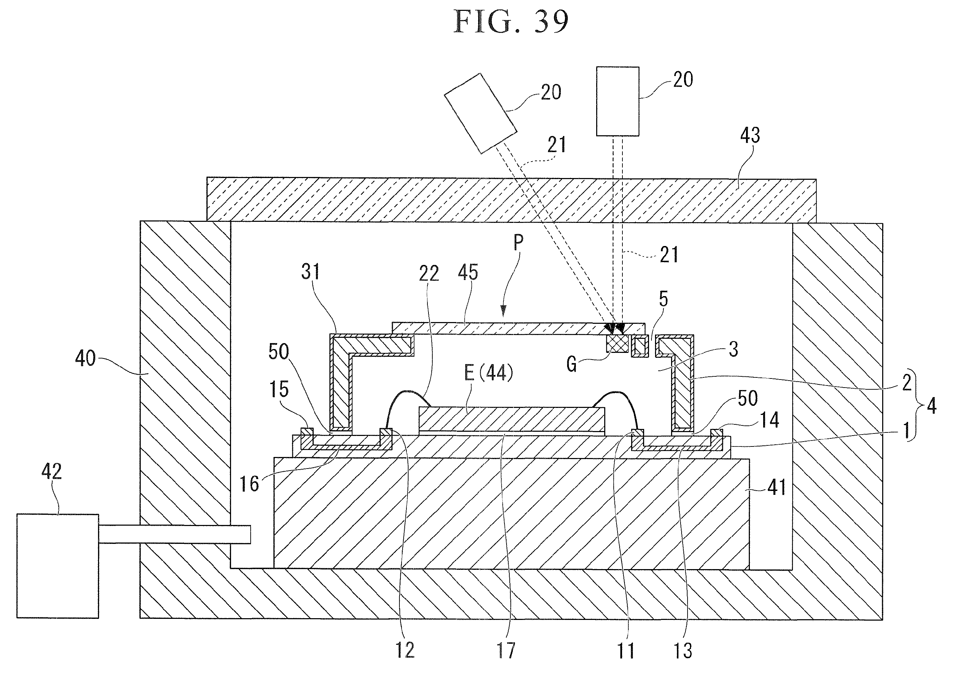

Also, FIG. 38 and FIG. 39 show a modification of the sixth exemplary embodiment. The portions that are the same as the constituent elements in FIG. 1 to FIG. 37 are denoted by the same reference symbols, and so explanations thereof are omitted. In addition, the basic constitution has identical portions, and here chiefly the points of difference therebetween shall be described.

In the modification of the sixth exemplary embodiment, as shown in FIG. 38, the through-hole 5 for evacuating the interior of the package main body portion 4 is formed adjacent to the getter material G that is mounted or formed within the hollow portion 3 of the package main body portion 4 and on the inner surface of the infrared ray transmissive window 45. The through-hole 5 is formed in the ceiling surface of the second main body portion 2 and at an adjacent position to the infrared ray transmissive window 45.

In another modification of the sixth exemplary embodiment, as shown in FIG. 39, prior to plugging the through-hole 5 for vacuum evacuation, it is placed on the stage 41 of the vacuum chamber 40 and the inside of the vacuum chamber 40 is vacuumed to thereby evacuate, through the through-hole 5, the interior of the hollow portion 3 of the package main body portion 4. At this time, the laser beam 21 is emitted from outside of the vacuum chamber 40 through the glass transmissive window 43 and the infrared ray transmissive window 45 onto the getter material G that has been mounted or formed on the surface of the infrared ray transmissive window 45, whereby the getter material G is heated and activated. The emission position of the laser beam 21 may be such that the laser is emitted from directly above the getter material G, or emitted from an obliquely upper direction as shown in FIG. 39.

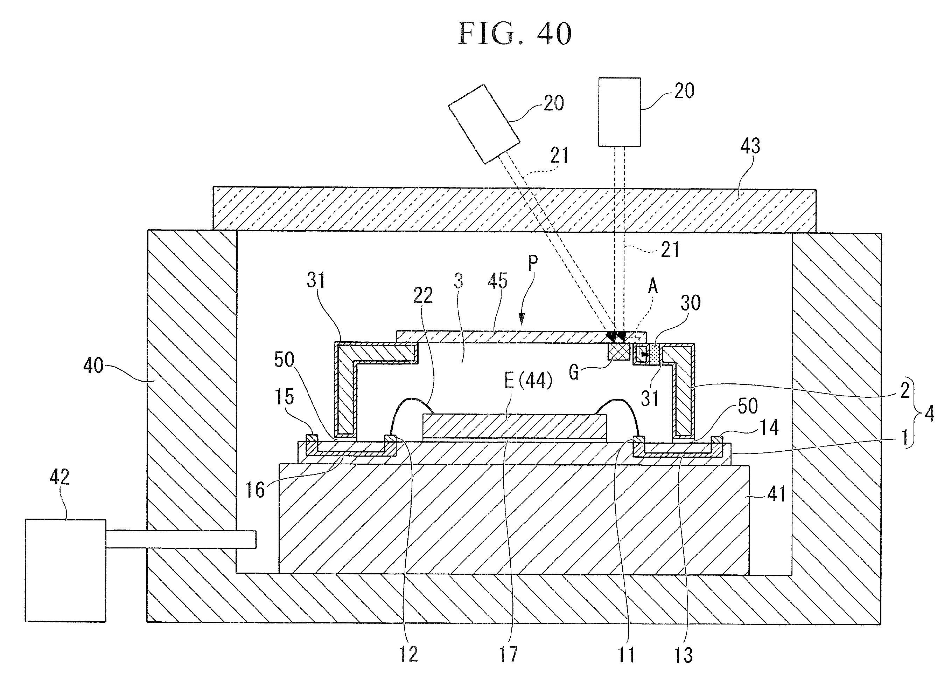

When continuing to emit the laser beam 21 onto the getter material G in the present process, a portion of the energy of the laser beam 21 is absorbed by the infrared ray transmissive window 45. As a result, a portion of the infrared ray transmissive window 45 that comes into contact with the laser beam 21 is heated, and the heat, as shown by the arrow A (FIG. 40), spreads to the periphery of the through-hole 5 that is formed at a location that is close to a portion of the infrared ray transmissive window 45, which has made contact with the laser beam 21. Accordingly, the low-melting-point portion 31, which is formed at the periphery and interior of the through-hole 5, melts, and the through-hole 5 is plugged by the low-melting-point portion 31. In the modification of the sixth exemplary embodiment, even without changing the emission position of the laser beam 21, by irradiating the getter material G, the temperature at the periphery of the through-hole 5 rises with the passage of time due to the residual heat. At the point in time at which the temperature becomes equal to or greater than the melting point of the low-melting-point portion 31, the low-melting-point portion 31 melts, and it is possible to plug the through-hole 5 with the low-melting-point portion 31. Thereafter, the emission of the laser beam 21 is halted.

Since the emission position of the laser beam 21 need not be changed, it is possible to shorten the series of process times of heating and activating the getter material G and plugging the through-hole 5.

[Exemplary Embodiment 7]

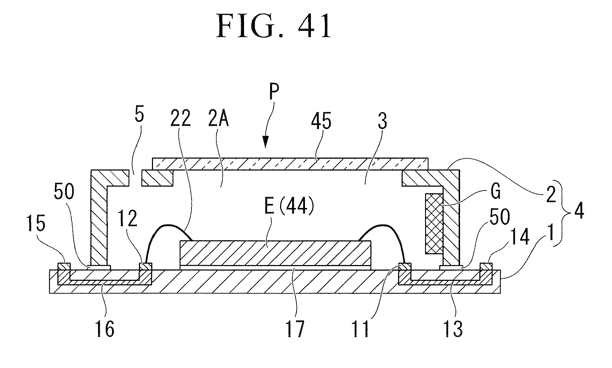

Next, a seventh exemplary embodiment of the present invention shall be described with reference to FIG. 41 to FIG. 50. In FIG. 41 to FIG. 50, portions corresponding to the constituent elements in FIG. 1 to FIG. 40 are denoted by the same reference symbols, and so explanations thereof are omitted. Hereinbelow, the points of difference with the aforementioned exemplary embodiments shall be described. FIG. 41 shows the state prior to plugging the through-hole 5 for vacuum evacuation.

In the seventh exemplary embodiment, the getter material G is mounted or formed within the hollow portion 3 of the package main body portion 4 and on the inner surface of the second main body portion 2. More specifically, as shown in FIG. 41, the getter material G is mounted or formed on the inside side surface of the second main body portion 2. This point is a point that differs from the structure of the fifth exemplary embodiment shown in FIG. 32.

As shown in FIG. 41, on the surface of the second main body portion 2, it is preferable that the low-melting-point portion 31 as described in the other exemplary embodiments not be formed in particular at the location where the getter material G is to be mounted or formed (film formed). This is because if the getter material G is mounted or formed (film formed) on the low-melting-point portion 31, when the getter material G is heated to 400°C to 900°C and activated, the low-melting-point portion 31 melts, and so the problem occurs of the getter material G exfoliating from the surface of the second main body portion 2.

Although there are no particular limitations on the mounting method or formation method of the getter material G, it is preferable to weld it to the surface of the second main body portion 2 having for example kovar and alloy 42 or the like as the main material, or film-form it on the surface of the second main body portion 2 using a film-formation technique such as a sputtering method or a vacuum deposition method.

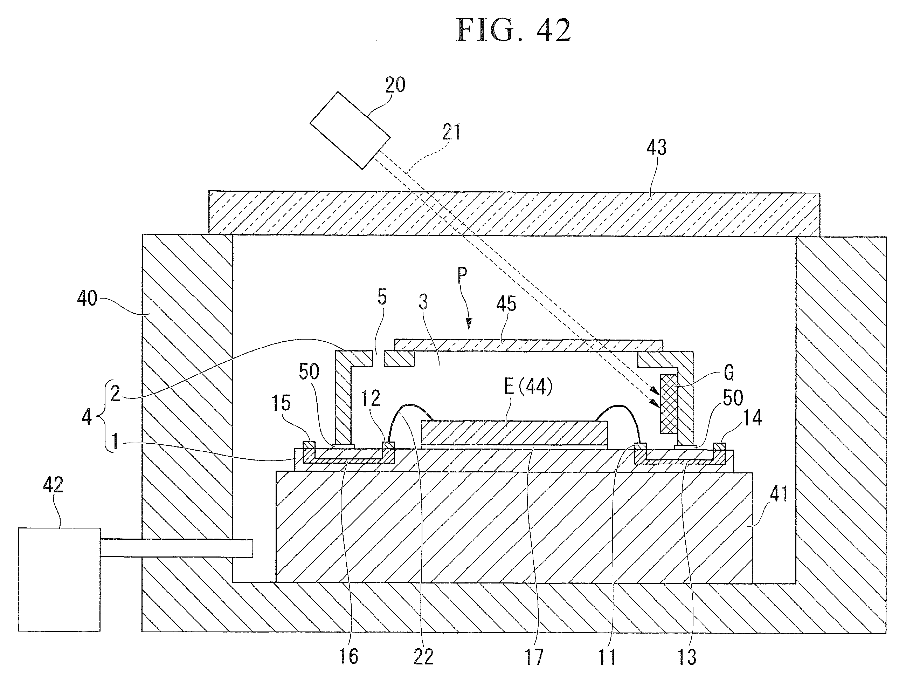

As shown in FIG. 42, the vacuum sealed package prior to plugging the through-hole 5 for vacuum evacuation of the seventh exemplary embodiment is placed on the stage 41 in a vacuum chamber 24, vacuum evacuation of the interior of the vacuum chamber 40 is performed, and the interior of the hollow portion 3 of the package main body portion 4 is vacuumed via the through-hole 5. At this time, the laser beam 21 is emitted from outside of the vacuum chamber 40 through the glass transmissive window 43 and the infrared ray transmissive window 45 onto the getter material G that is mounted or formed on the surface of the second main body portion 2, whereby it heats the getter material G and causes it to be activated.

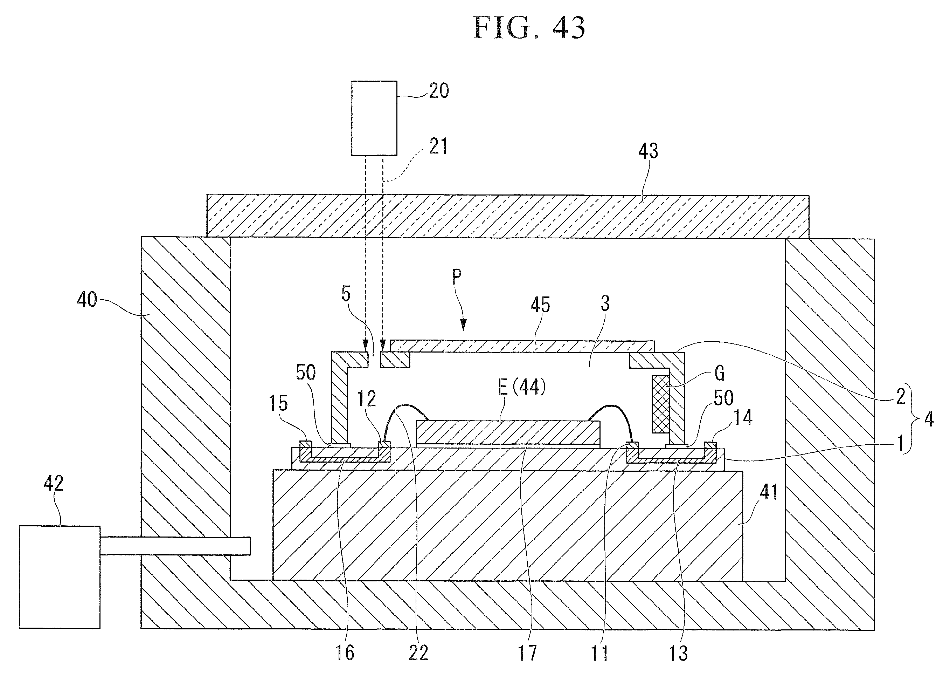

While performing this vacuum evacuation, after the getter material G is heated and activated, the laser beam 21 is emitted from outside of the vacuum chamber 40 through the infrared ray transmissive window 45 onto the lid surface of the periphery of the through-hole 5 as shown in FIG. 43 to heat it to at least the melting point of the material that constitutes the second main body portion 2 at the periphery of the through-hole 5. Thereby, the through-hole 5 is plugged by the constituent material of the second main body portion 2 that has melted, and the vacuum sealed package P of the seventh exemplary embodiment of the present invention is completed (a figure showing the appearance after plugging the through-hole 5 is omitted).

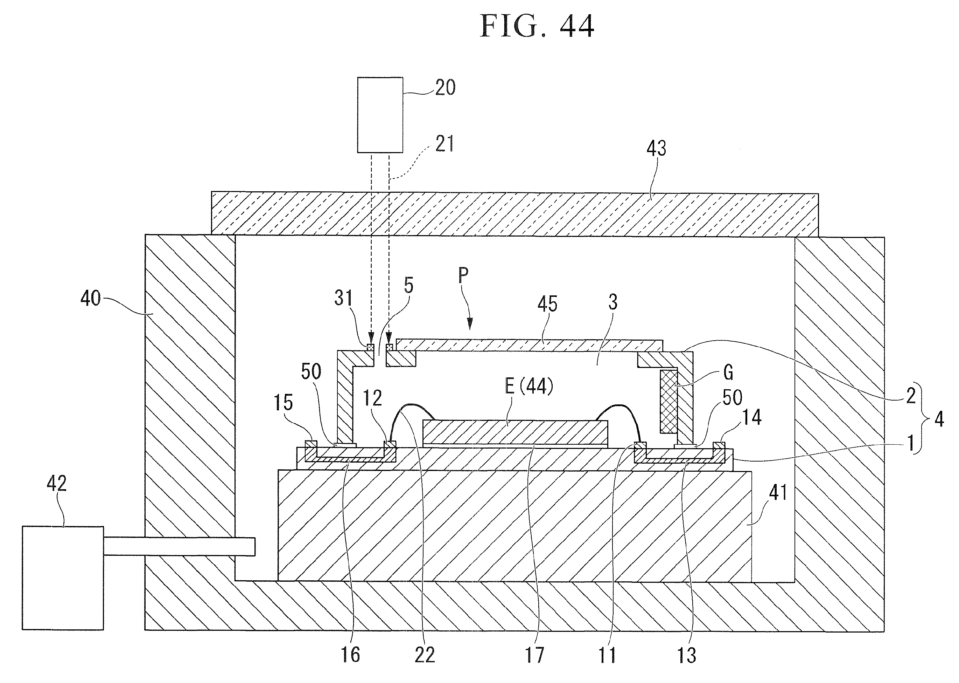

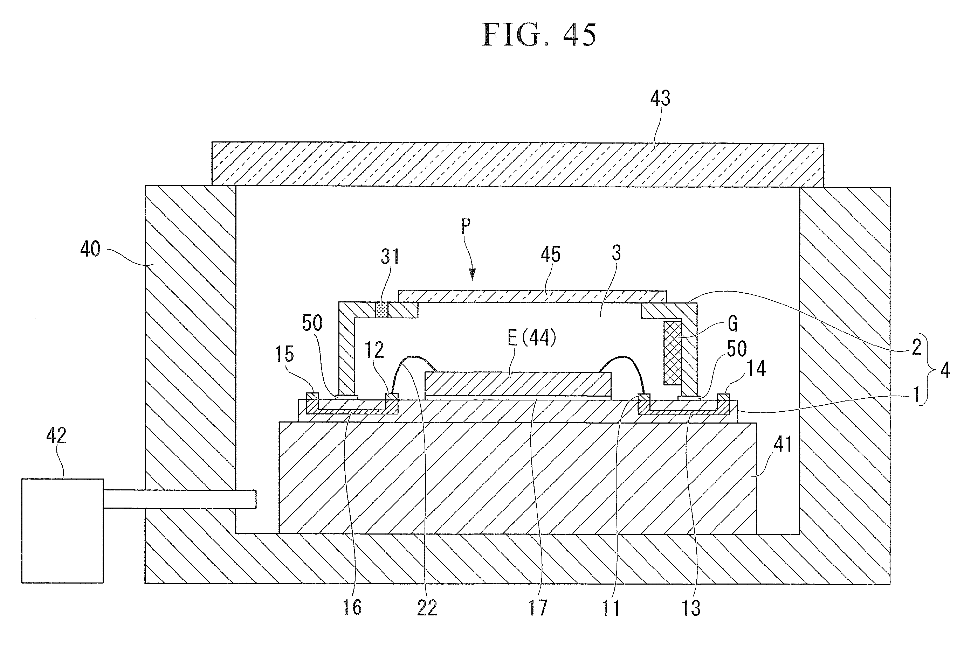

As shown in FIG. 44, the low-melting-point portion 31 is formed in advance only at the periphery of the through-hole 5, or the low-melting-point portion 31 is placed at the periphery of the through-hole 5 when putting the package main body portion 4 in the vacuum chamber. In this case, by emitting the laser beam 21 from outside of the vacuum chamber 40 through the infrared ray transmissive window 45 onto the low-melting-point portion 31 at the periphery of the through-hole 5 after heating and activating the getter material G and causing the low-melting-point portion 31 to melt, the through-hole 5 is plugged by the low-melting-point portion 31. The vacuum sealed package P of the seventh exemplary embodiment of the present invention may be manufactured using this kind of means. FIG. 45 shows the sealed member that is formed by plugging the through-hole 5 with the low-melting-point portion 31.

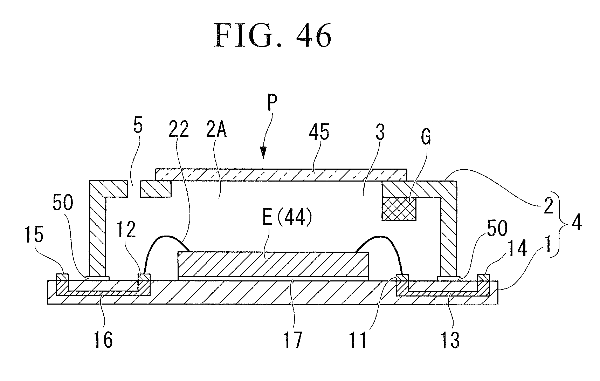

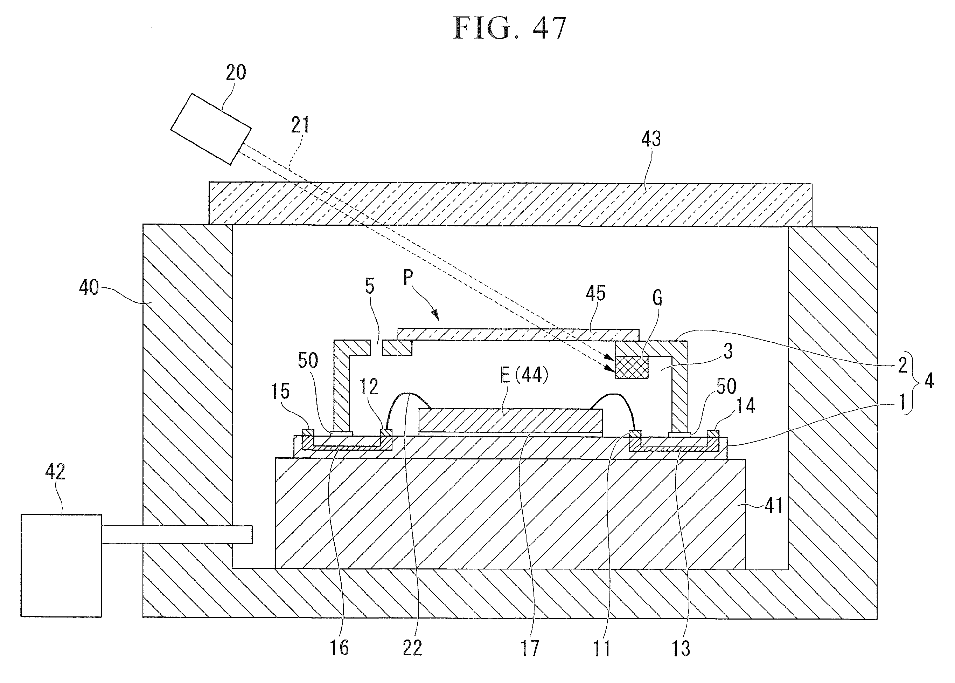

FIG. 46 shows the state prior to plugging the through-hole 5 for vacuum evacuation in the vacuum sealed package of a modification of the seventh exemplary embodiment of the present invention. In the present modification, the getter material G is mounted on the inside ceiling surface of the second main body portion 2. In FIG. 47, the preceding modification shown in FIG. 46 is placed on the stage 41 of the vacuum chamber 40 and the inside of the vacuum chamber 40 is vacuumed. While performing vacuum evacuation, through the through-hole 5, of the interior of the hollow portion 3 of the package main body portion 4, the laser beam 21 is emitted from outside of the vacuum chamber 40 through the glass transmissive window 43 and the infrared ray transmissive window 45 onto the getter material G that has been mounted or formed on the surface of the infrared ray transmissive window 45. Thereby, the getter material G is heated and activated. The laser beam 21 is emitted from an obliquely upper direction onto the getter material G as shown in FIG. 47.

Thereafter, although not depicted in the figure, while performing vacuum evacuation in this manner the getter material G is heated and activated. Subsequently, the laser beam 21 is emitted from outside of the vacuum chamber 40 through the infrared ray transmissive window 45 onto the lid surface of the periphery of the through-hole 5 similarly to the seventh exemplary embodiment as shown in FIG. 43 to FIG. 45 to heat it to at least the melting point of the material that constitutes the second main body portion 2 or the low-melting-point portion 31 at the periphery of the through-hole 5. Thereby, the through-hole 5 is plugged by the melted material, and the modification of the seventh exemplary embodiment of the present invention is completed.

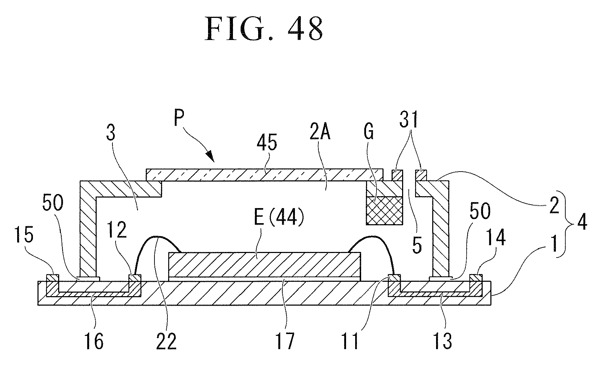

In the modification of the seventh exemplary embodiment of the present invention shown in FIG. 46 and FIG. 47, the through-hole 5 for vacuum evacuation of the package main body portion 4 was shown at a position away from the getter material G, but as another modification that is similar to this, a structure is also possible in which the through-hole 5 is provided in the vicinity of the getter material G as shown in FIG. 48.

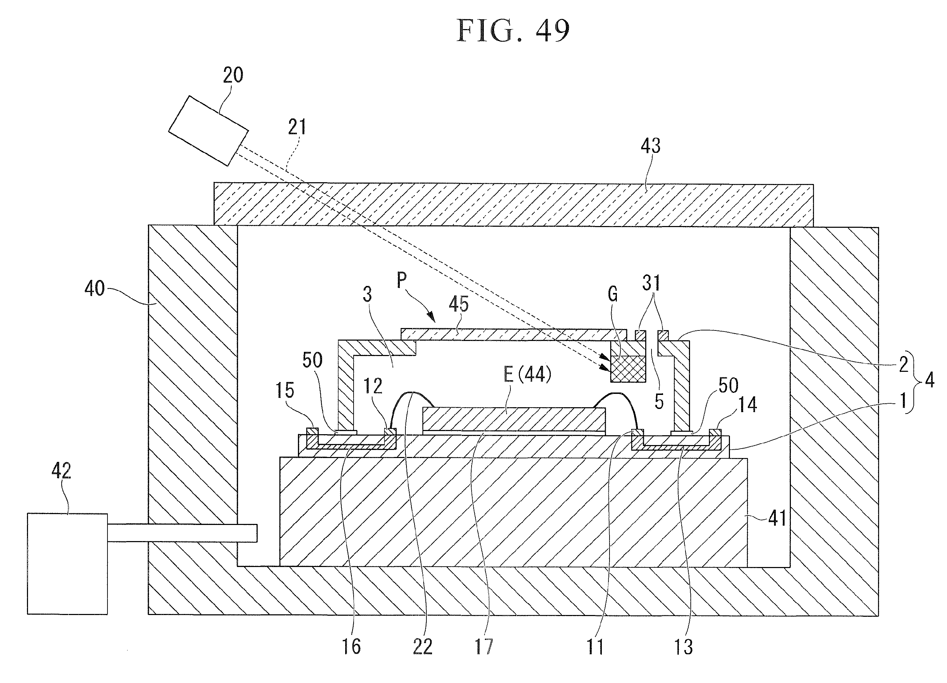

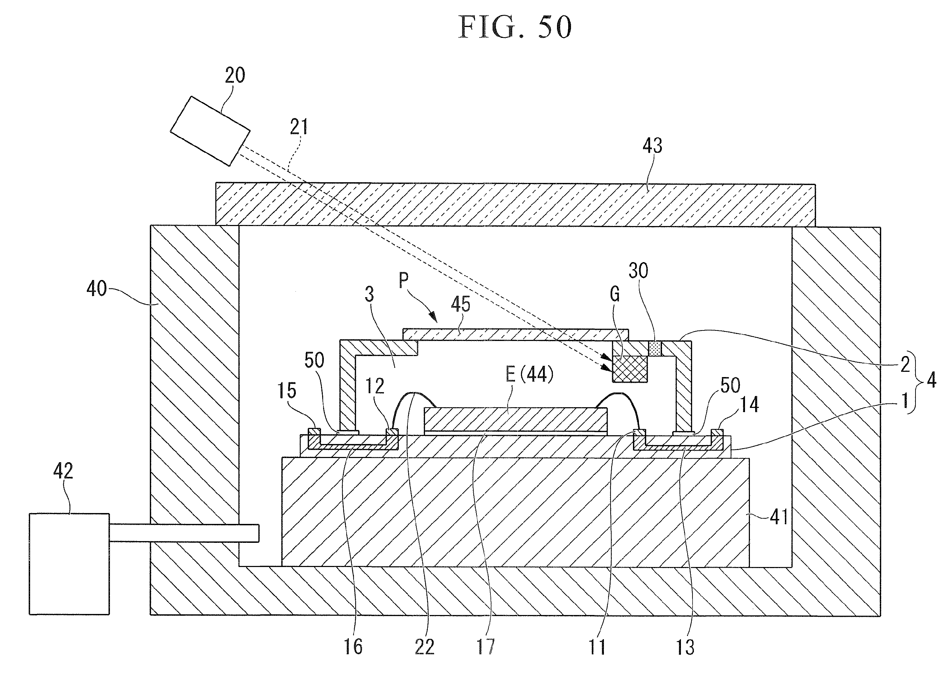

By adopting the structure shown in FIG. 48, as shown in FIG. 49, the package main body portion 4 is placed on the stage 41 of the vacuum chamber 40, and the inside of the vacuum chamber 40 is vacuumed to thereby evacuate, through the through-hole 5, the inside of the hollow portion 3 of the package main body portion 4. At this time, the laser beam 21 is emitted from outside of the vacuum chamber 40 through the glass transmissive window 43 and the infrared ray transmissive window 45 onto the getter material G that is mounted or formed on the surface of the second main body portion 2, whereby it heats the getter material G and causes it to be activated. Thereby, the heat of the getter material G that has been heated spreads to the periphery of the through-hole 5 positioned in the vicinity of the getter material G and melts the low-melting-point portion 31 that is mounted or formed at the periphery of the through-hole 5, and so it is possible to ultimately plug the through-hole 5 by the low-melting-point portion 31 as shown in FIG. 50.

In the modification of the seventh exemplary embodiment shown in FIG. 48, the same effect is obtained as the modification of the sixth exemplary embodiment of the present invention that is shown in FIG. 38 to FIG. 40. Even without changing the emission position of the laser beam 21, by irradiating the getter material G, the temperature at the periphery of the through-hole 5 rises with the passage of time, and at the point in time at which the temperature becomes equal to or greater than the melting point of the low-melting-point portion 31, the low-melting-point portion 31 melts. Thereafter, by halting emission of the laser beam 21, it is possible to plug the through-hole 5 with the low-melting-point portion 31. Since the emission position of the laser beam 21 need not be changed, it is possible to shorten the series of process times of heating and activating the getter material G and plugging the through-hole 5.

[Exemplary Embodiment 8]

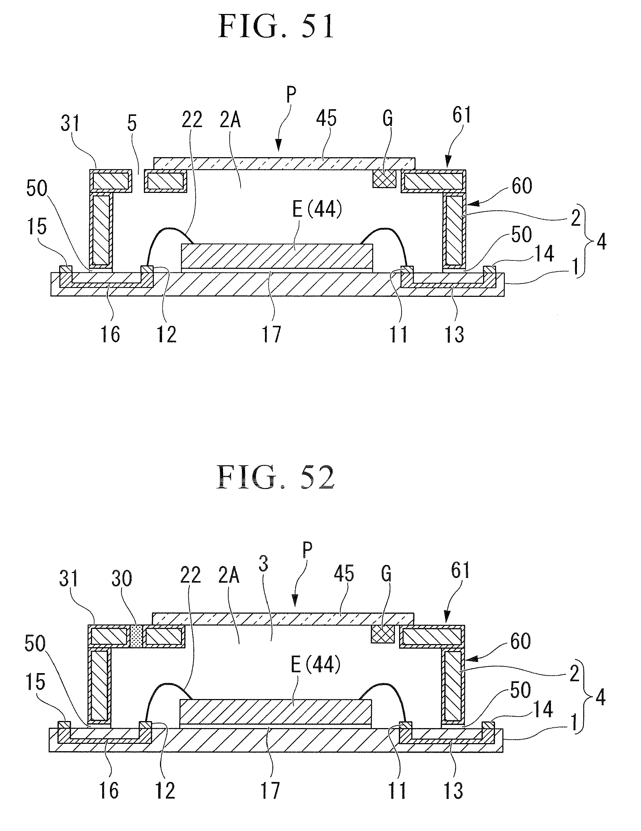

Next, an eighth exemplary embodiment of the present invention shall be described with reference to FIG. 51 to FIG. 58. In FIG. 51 to FIG. 58, portions corresponding to the constituent elements in FIG. 1 to FIG. 50 are denoted by the same reference symbols, and so explanations thereof are omitted. Hereinbelow, the points of difference with the aforementioned exemplary embodiments shall be described.

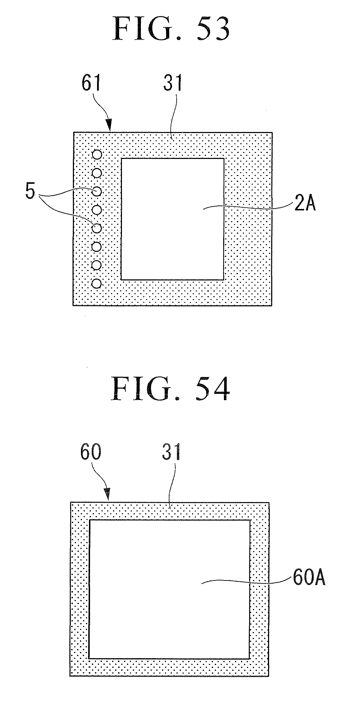

FIG. 51 shows the state prior to plugging the through-hole 5 for vacuum evacuation, and FIG. 52 shows the state after plugging the through-hole 5. Also, FIG. 53 to FIG. 55 show components that constitute the second main body portion 2 that serves as the lid member of the package main body portion 4 used in the present exemplary embodiment.

In the vacuum sealed package P in the present eighth exemplary embodiment, the second main body portion 2 that is a lid member that encompasses the infrared ray receiving element 44 is constituted by joining a frame member 60 (shown in FIG. 54), a plate member 61 (shown in FIG. 53), and the infrared ray transmissive window 45. The frame member 60 has an opening 60A formed in the center thereof so as to enclose the hollow portion 2A, and has a size and thickness that can house the infrared ray receiving element 44 within the opening 60A. Also, the getter material G is mounted or formed in advance on the surface of the infrared ray transmissive window 45.

Here, the ring-shaped frame member 60 and plate member 61 are joined by the low-melting-point portion 31 having a lower melting point than the material that constitutes the respective structures that is formed in advance on their respective surfaces.

In general, it is not easy to manufacture a second main body portion 2 that has a hollow portion capable of containing the infrared ray receiving element 44. While there is for example a means that forms a hollow portion 3 that can contain the infrared ray receiving element 44 by etching, it is difficult to form the shape of a space with dimensional accuracy. In contrast, according to the vacuum sealed package P of the present exemplary embodiment, the frame member 60, which has the opening 60A formed in the center thereof and has the size and thickness capable of containing the infrared ray receiving element 44 inside of the opening 60A, is bonded with the plate member 61 to thereby manufacture the second main body portion 2. Therefore, it is possible to easily manufacture the second main body portion 2 at a low cost.

FIG. 51 to FIG. 54 show an example of the low-melting-point portion 31 being formed on the surface of the frame member 60 and the rectangular plate member 61. It is also applicable to the case of this low-melting-point portion 31 not being present (for example, the example shown in the seventh exemplary embodiment of the present invention) and to examples described in the other exemplary embodiments.

In the case of this low-melting-point portion 31 being absent on the surface in the first place, for example a fixing material such as solder or the like is subsequently formed on the surface of the ring-shaped frame member 60 and the plate-shaped member 61, and they are fused together. Alternatively, if they are the same material, they are both bonded by a bonding means such as surface activated bonding, thermal compression bonding, ultrasonic bonding, anode bonding, and the like.

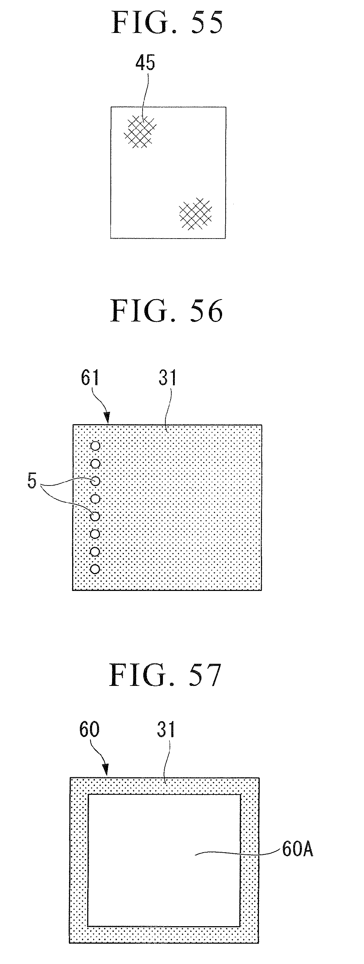

In the aforementioned exemplary embodiment, the example was described of the infrared ray receiving element 44 being vacuum sealed, but in the case of using an electronic device E other than the infrared ray receiving element 44, the infrared ray transmissive window 45 shown in FIG. 55 is not required. Accordingly, the second main body portion 2 may be manufactured by bonding the plate member 61 in which an opening is not provided as shown in FIG. 56 with the plate member 60 shown in FIG. 57.

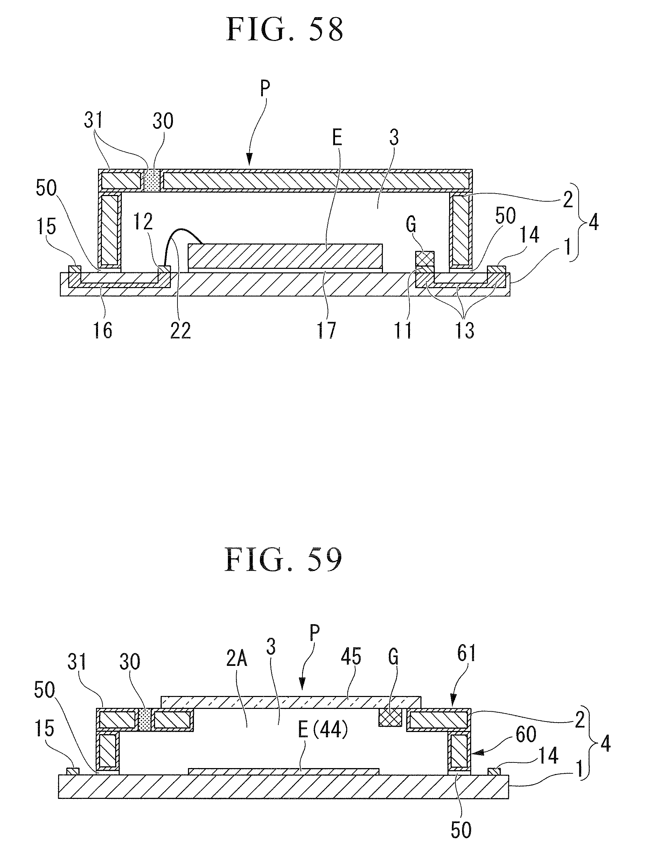

FIG. 58 shows a cross-sectional view of the vacuum sealed package P that is a modification of the present exemplary embodiment (the state after plugging the through-hole 5 for vacuum evacuation). This vacuum sealed package P uses an electronic device E other than the infrared ray receiving element 44. In the present exemplary embodiment, since there is no infrared ray transmissive window 45, in the same manner as the first exemplary embodiment and the second exemplary embodiment of the present invention, by heating the third conductor pad 14 that is provided outside of the package main body portion 4, heat is transmitted from the third conductor pad 14 to the first conductor pad 11 via the thermally conductive material 13, whereby the getter material G that is mounted or formed on the first conductor pad 11 is indirectly heated and activated. Since this is described in detail in the first exemplary embodiment and Second exemplary embodiment, the description thereof shall be omitted here.

[Exemplary Embodiment 9]

Next, a ninth exemplary embodiment of the present invention shall be described with reference to FIG. 59. FIG. 59 shows the vacuum sealed package P according to the ninth exemplary embodiment of the present invention (the state after plugging the through-hole 5 for vacuum evacuation). In the present exemplary embodiment, those portions that are the same as the constituent elements in FIG. 1 to FIG. 58 are denoted by the same reference symbols, and so explanations thereof are omitted. In addition, here only the points of difference therebetween shall mainly be described.

The aforedescribed first exemplary embodiment to eighth exemplary embodiment showed examples of the electronic device E (including the infrared ray receiving element 44) being mounted in the first package main body portion 4 or on the wiring substrate 10 via a bonding material. In the vacuum sealed package P in the ninth exemplary embodiment of the present invention shown in FIG. 59, an integrated circuit that is the main portion of the electronic device E (including the infrared ray receiving element 44) is formed directly on the first package main body portion 4. If for example Si is used for the underlying substrate material that serves as the base of the wiring substrate, it is possible to form a plurality of integrated circuits at once on an Si wafer, and so it is possible to reduce the per-piece cost of the wiring substrate 10 (including the integrated circuit). In FIG. 59, although the portrayal of the electrical wiring from the infrared ray receiving element 44 used as the electronic device to the fourth conductor pad 15 serving as the external terminal of the package main body portion 4 is omitted, the integrated circuit of the electronic device E (including the infrared ray receiving element 44) and the fourth conductor pad 15 are electrically connected.

In the case of the present exemplary embodiment, since the integrated circuit of the electronic device E (including the infrared ray receiving element 44) that is formed on the first package main body portion 4 has a thin thickness (several 10 $\mu$m), there is the advantage in that the vacuum sealed package P can be made thin, and since there is no need to use a bonding material, there is the advantage in that gas release inside the package is unlikely after it has been vacuum sealed.

[Exemplary Embodiment 10]

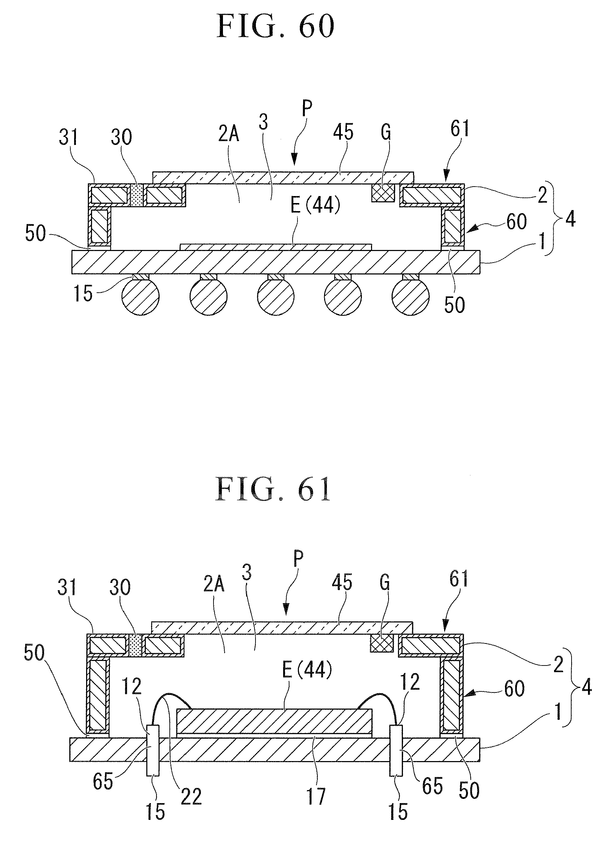

Next, a tenth exemplary embodiment of the present invention shall be described. FIG. 60 shows the vacuum sealed package P according to the tenth exemplary embodiment of the present invention (the state after plugging the through-hole 5 for vacuum evacuation). In FIG. 60 that describes the present exemplary embodiment, those portions that are the same as the constituent elements in FIG. 1 to FIG. 59 are denoted by the same reference symbols, and so explanations thereof are omitted. In addition, here only the points of difference therebetween shall chiefly be described.

In the exemplary embodiments 1 to 9 of the present invention described hitherto, the fourth conductor pad 15 that serves as the external terminal of the package main body portion 4 is formed on the same surface side as the surface on which the electronic device E (including the infrared ray receiving element 44) is mounted or formed, in the main body portion 1 that includes the wiring substrate 10 of the package main body portion 4. In the tenth exemplary embodiment, the fourth conductor pad 15 (the pad serving as the external terminal of the package main body portion 4) is formed on the reverse-opposite side of the surface on which the electronic device E (the infrared ray receiving element 44 in FIG. 60) is mounted or formed. A solder ball (a conductive ball composed of a material such as Sn, SnPb, SnAg, SnAgCu, SnCu, SnIn, SnZn, SnBi, SnZnBi or the like) is formed by means of reflowing or the like on the fourth conductor pad 15, thereby realizing a package capable of flip-chip mounting.

According to this constitution, since there is no need to provide the fourth conductor pad 15 further to the outside than the second main body portion 2 that serves as the lid member of the package main body portion 4, it can be made smaller than the first to ninth exemplary embodiments of the present invention. Also, in the present exemplary embodiment shown in FIG. 60, since the electronic device E (the infrared ray receiving element 44 in FIG. 60) is formed directly on the first main body portion 1 of the package main body portion 4 similarly to the ninth exemplary embodiment of the present invention, it is possible to make the package main body portion 4 thin. That is to say, it is possible to realize a vacuum sealed package P that is compact and thin.

[Exemplary Embodiment 11]

Next, an eleventh exemplary embodiment of the present invention shall be described. FIG. 61 shows the vacuum sealed package P according to the eleventh exemplary embodiment of the present invention (the state after plugging the through-hole 5 for vacuum evacuation). In FIG. 61, those portions that are the same as the constituent elements in FIG. 1 to FIG. 60 are denoted by the same reference symbols, and so explanations thereof are omitted. In addition, here only the points of difference therebetween shall chiefly be described.

The eleventh exemplary embodiment is similar to the tenth exemplary embodiment, with the fourth conductor pad 15 being formed on the reverse-opposite side of the surface on which the electronic device E (including the infrared ray receiving element 44) is mounted or formed. It differs slightly from the tenth exemplary embodiment by the second conductor pad 12 being electrically connected with the fourth conductor pad 15 via a pin-shaped conductor 65. The pin-shaped conductor 65 penetrates the first main body portion 1 of the package main body portion 4, and extends from the inside of the hollow portion 3 to the outside of the package main body portion 4. The first main body portion 1 of the package main body portion 4 and the pin-shaped conductor 65 are bonded in close contact by welding or the like.

According to this constitution, since there is no need to provide the fourth conductor pad 15 further to the outside than the second main body portion 2 similarly to the tenth exemplary embodiment of the present invention, it can be made smaller than the first to ninth exemplary embodiments of the present invention.

[Exemplary Embodiment 12]

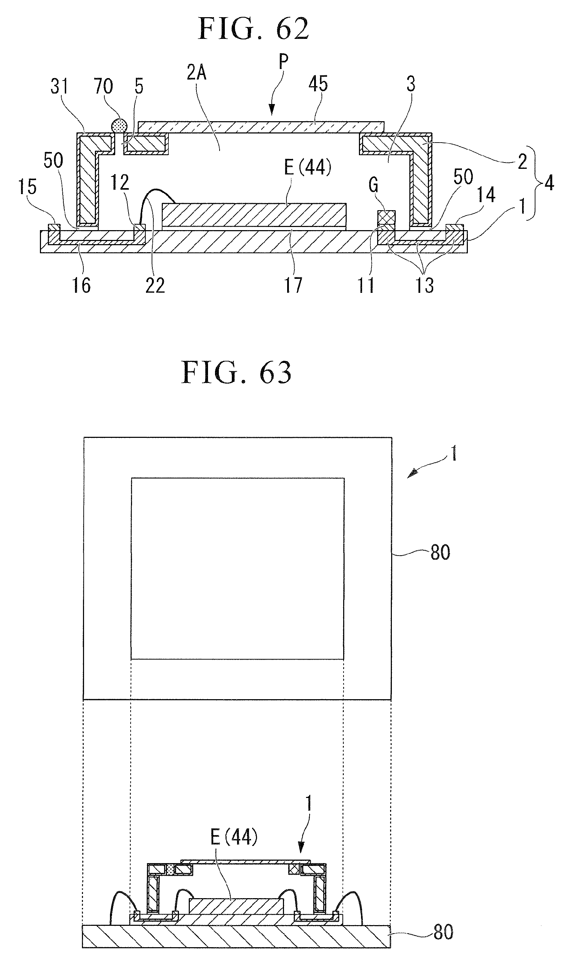

Next, a twelfth exemplary embodiment of the present invention shall be described. FIG. 62 shows the vacuum sealed package P according to the twelfth exemplary embodiment of the present invention (the state prior to plugging the through-hole 5 for vacuum evacuation). In FIG. 62, those portions that are the same as the constituent elements in FIG. 1 to FIG. 61 are denoted by the same reference symbols, and so explanations thereof are omitted. In addition, here only the points of difference therebetween shall chiefly be described.

In the twelfth exemplary embodiment, only the method of plugging the through-hole 5 differs from the other exemplary embodiments. That is, the package main body portion 4 is placed in a vacuum chamber, and a spherical low-melting-point metal material 70 such as a solder alloy ball that includes for example Sn is placed on the through-hole 5, and vacuum evacuation is performed from the clearance between the spherical low-melting-point metal material 70 and the through-hole 5. Subsequently, after activating the getter 6 by the same method as the first exemplary embodiment or the second exemplary embodiment, the laser beam 21 is emitted on the spherical low-melting-point metal material 70 on top of the through-hole 5 by the same method, and the through-hole 5 is plugged by melting the spherical low-melting-point metal material 70.

[Exemplary Embodiment 13]

Next, a thirteenth exemplary embodiment of the present invention shall be described. FIG. 63 shows the vacuum sealed package P according to the thirteenth exemplary embodiment of the present invention. In FIG. 63, those portions that are the same as the constituent elements in FIG. 1 to FIG. 62 are denoted by the same reference symbols, and so explanations thereof are omitted. This exemplary embodiment has the same basic constitution as the aforementioned first exemplary embodiment, and here only the points of difference therebetween shall mainly be described.

The present exemplary embodiment is one that is constituted as a printed circuit board 80 with the vacuum sealed package P mounted thereon. That is to say, the printed circuit board 80 includes a vacuum sealed package P that uses an electronic device E (including the infrared ray receiving element 44).

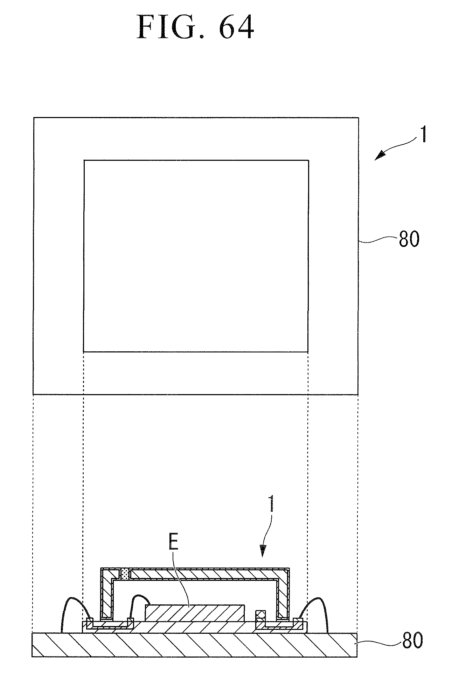

As the vacuum sealed package P, it is possible to apply any of the vacuum sealed packages P in the exemplary embodiments described above. Also, as shown in FIG. 64, the printed circuit board 80 may be equipped with a vacuum sealed package P of the type without the infrared ray transmissive window 45. In any of these cases, by mounting these vacuum sealed packages P, it is possible to manufacture a low cost printed circuit board 80 that offers a higher level of freedom in structure designing.

Note that it is possible to assemble an electronic device using the vacuum sealed package P in the above-described twelfth exemplary embodiment, or the printed circuit board 80 in the above-described thirteenth exemplary embodiment. That is to say, it is possible to constitute an electronic device including the above-described vacuum sealed package P or the printed circuit board 80, and according this electronic device, manufacturing cost can be lowered compared to that of the conventional practice. Examples of electronic devices to which this may be applied include, for example, an infrared camera in which is mounted the vacuum sealed package P of the infrared ray receiving element (infrared ray sensor) 44 or a module substrate (printed circuit board) having the vacuum sealed package P, or a thermography that enables the temperature distribution of an object to be visualized. Moreover, even when the electronic device E is a device other than the infrared ray receiving element (infrared ray sensor) 44, for example, it is still suitable for vehicle onboard electronic devices in which malfunctioning is not permitted even in high temperature or high humidity environments (car navigation, car audio, electronic toll collection (ETC) device, and the like), and for electronic devices for use in the water in which water ingress is not tolerated (underwater camera, underwater sonar device, and the like) are suitable. Hereinabove, a plurality of exemplary embodiments have been described, but the present invention should not be considered as being limited to the above-described exemplary embodiments provided it does not exceed the scope thereof.

[Exemplary Embodiment 14]

As a fourteenth exemplary embodiment of the present invention, a vacuum sealed package P that uses the infrared ray receiving element (infrared ray sensor) 44 shall be described with reference to FIG. 35, FIG. 36, FIG. 37, FIG. 53, FIG. 54, and FIG. 55.

First, an Si substrate measuring 10 mm × 13 mm and having a thickness of 0.2 mm was prepared as the infrared ray transmissive window 45 (FIG. 55). An antireflection film was formed in advance on the Si substrate. Moreover, Ni (3 $\mu$m)/Au (0.05 $\mu$m) was formed by means of a nonelectrolytic plating method in an area 1 mm wide to the inside from the outermost periphery of the Si substrate. The reason for this was to easily perform bonding to a SnAg film that is formed on the surface of the second main body portion 2 that serves as the lid member to be subsequently bonded, while providing superior wettability without the use of flux. Also, after forming the Ni/Au film, a getter material G was formed on the periphery of the Si substrate as shown in FIG. 35 by a vacuum sputtering method.

Next, there were prepared a plate member 61 having an outer diameter of 15 mm × 15 mm, an inner diameter of 8 mm × 11 mm (the diameter of the opening of the opening portion 2A), and a thickness of 0.2 mm as shown in FIG. 53, and a ring-shaped frame member 60 with an outer diameter of 15 mm × 15 mm, an inner diameter of 13 mm × 13 mm, and a thickness of 1.5 mm as shown in FIG. 54 with an opening 60A formed in the center thereof, and having a size and thickness capable of housing the electronic device E inside the opening 60A.

The materials shown in FIG. 53 and FIG. 54 were manufactured using 42 alloy (alloy ofNi and Fe). The through-holes 5 shown in FIG. 53 were formed as through-holes with a maximum diameter of 0.2 mm by means of chemical etching with the use of a mask. There were formed four through-holes (although FIG. 53 illustrates this as though eight holes were formed). The shape of the inside of the through-hole 5 was formed in a slightly tapered shape by means of an etching method, and the minimum diameter of the through hole 5 was 0.17 mm. Moreover, an approximately 50 $\mu$m SnAg (3.5%) film was formed on the surface of these materials and inside the through-hole 5 by means of an electrolytic plating method. As a result, the opening diameter of the micro through-hole 5 was made 0.07 mm to 0.1 mm.

A wiring substrate with an outer diameter of 18 mm × 18 mm and a thickness of 0.5 mm, the insulative base material of which consisting of glass ceramics, was used as the first main body portion 1 shown in FIG. 35. Ni·(3 $\mu$m)/Au (0.05 $\mu$m) was preliminarily formed on the surface of the conductor pattern 50 on the wiring substrate, the second conductor pad 12, and the fourth conductor pad 15 by means of an nonelectrolytic plating method. Furthermore, the width 51 of the conductor pattern on the wiring substrate to be bonded with the ring-shaped frame member 60 was 1.2 mm, and was designed larger than the bonding width 1.0 mm (in reality, the thickness of a SnAg plating is added thereto, making it approximately 1.1 mm) of the ring-shaped frame member 60.

Next, the electronic device E (infrared ray receiving element 44 in the present exemplary embodiment) was adhesively fixed to the first main body portion 21 that includes the wiring substrate 10 by a bonding material, and then, the infrared ray receiving element 44 and the second conductor pad 12 on the wiring substrate 10 were bonded with the wire 22 that has Al as its material.

Subsequently, the conductor pattern 50 on the wiring substrate 10, the ring-shaped frame member 60, the plate member 61, and the infrared ray transmissive window 45 were position-aligned and laminated, and they were then collectively bonded using a nitrogen reflow furnace, whereby the package main body portion 4 shown in FIG. 35 (prior to plugging the through-hole 5 in a vacuum) was manufactured.

Next, the package main body portion 4 prior to vacuum sealing shown in FIG. 35 was installed inside the vacuum chamber 40 as shown in FIG. 36. The interior of the vacuum chamber 40 was evacuated with a rotary pump and a turbo-molecule pump to thereby evacuate, through the through-holes 5, the inside of the package main body portion 4 to $10^{-6}$ Torr or less. While performing the vacuum evacuation, the entire vacuum chamber 40 and the stage 41 were heated to approximately 150°C, and moisture adhering to the surfaces of the interior of the vacuum chamber 40 and the surfaces of the interior of the package main body portion 4 was evaporated. Moreover, by performing evacuation with the vacuum pump, as much moisture as possible was removed. A heater is wound around the vacuum chamber 40, and the vacuum chamber 40 is heated by this heater.

Thereafter, the laser beam 21 was emitted from the laser apparatus 20 installed outside of the vacuum chamber 40, passing through the infrared ray transmissive window 45 on the package main body portion 4 onto the getter material G (placed inside the package main body portion 4 and on the surface of the infrared ray transmissive window 45), and the getter material G was heated to approximately 800°C and activated for several 10s of seconds. The laser beam 21 was emitted from above the getter material G.

Thereafter, the laser beam 21 emission portion of the laser apparatus 20 was moved to be positioned approximately directly over the through-hole 5 provided in the package main body portion 4, and the laser beam 21 was emitted from the laser apparatus 20 through the glass transmissive window 43 onto the periphery of the through-hole 5 of the package, and the SnAg film that serves as the low-melting-point portion 31 formed at the periphery of the through-hole 5 was melted to plug the through-hole 5, whereby the vacuum sealed package was manufactured.

Here, the spot diameter of the laser beam 21 was 0.4 mm. The dimensions A, B, C, and D are preferably $CB^2/(D^2 - B^2) \leq A$ and $B < D$, in the case where the thickness of the SnAg film is A (0.05 mm), the diameter of the through-hole 5 after the SnAg film has been formed is B (maximum value of 0.1 mm), the thickness of the structure having the through-hole 5 formed therein is C (0.2 mm), and the spot diameter of the laser beam 21 is D (0.4 mm). By putting the dimensions of A, B, C, and D in the range defined by the aforementioned formulas, it was possible to reliably plug the through-hole 5 with the SnAg material.

When the present vacuum sealed package P was mounted in an infrared camera, acquisition of the required image was confirmed. Moreover, after manufacturing this vacuum sealed package P, it could be confirmed that the required image was obtained in the same manner after one year.

In the fourteenth exemplary embodiment of the present invention as described in detail above, since it is possible to heat the getter material G on the first conductor pad 11 in the hollow portion 3 of the package main body portion 4 via the thermally conductive material 13 after evacuating the interior of the hollow portion 3 of the package main body portion 4 and sealing it, in a package of a type that performs sealing of the package main body portion 4 in a state of the interior being evacuated in advance, it is possible to maintain the vacuum state after sealing of the package main body portion 4 and possible to significantly improve the productivity of the package with a simple system that does not use a costly vacuum apparatus such as disclosed in Patent Documents 1 to 3 (one with a movable machine component provided therein, or a robot handling mechanism or the like provided therein).

In the exemplary embodiment of the present invention, the low-melting-point portion 31, which is comprised of a low-melting point metal material having a lower melting point than the package main body portion 4, is provided in the vicinity of the through-hole 5, and the low-melting-point portion 31 is heated and melted, thereby forming a portion or all of the sealing member 30 that plugs the through-hole 5. Thereby, in a conventional structure in which the main material itself of the package main body portion 4 is exposed without a low-melting-point metal film on the interior of the through-hole 5, time is required for plugging the interior of the through-hole 5 due to the occurrence of a wetting defect. In contrast, in the present exemplary embodiment, by heating the low-melting-point portion 31, the low-melting-point portion 31 has good wet-spreading also in the interior of the through-hole 5, and so there is the advantage of being able to reliably plug the through-hole 5. That is, in a package of a type that performs sealing of the package main body portion 4 in the state of the interior being evacuated in advance, it is possible to perform sealing of the package main body portion 4 with a simple system, and possible to significantly improve the productivity thereof.

Hereinabove, the exemplary embodiments of the present invention were described in detail with reference to the drawings, but specific constitutions are not restricted to these exemplary embodiments, and various design modifications are included without departing from the scope of the present invention.

Priority is claimed on Japanese Patent Application No. 2009-36511, filed February 19, 2009, the content of which is incorporated herein by reference.

INDUSTRIAL APPLICABILITY

The present invention can be applied to a vacuum sealed package of an electronic device such as an infrared light detector (infrared ray sensor), gyro sensor (angular velocity sensor), temperature sensor, pressure sensor, and acceleration sensor that are used in thermography, car navigation, car audio, ETC devices, underwater cameras, underwater sonar devices, and the like.

Reference Symbols

| | |
|---|---|
| 1 | First main body portion |
| 2 | Second main body |
| 2A | Opening portion |
| 3 | Hollow portion |
| 4 | Package main body portion |
| 5 | Through-hold |
| 6 | Exhaust tube |
| 7 | Sealing member |
| 10 | Wiring substrate |
| 11 | First conductor pad |
| 12 | Second conductor pad |
| 13 | Thermally conductive material |
| 14 | Third conductor pad |
| 15 | Fourth conductor pad |
| 20 | Laser apparatus |
| 21 | Laser beam |
| 30 | Sealing member |
| 31 | Low-melting-point portion |
| 40 | Vacuum chamber |
| 42 | Vacuum pump |

43 Glass transmissive window
44 Infrared ray receiving element
50 Conductor pattern
52 Bonding surface
53 Bonding portion
60 Frame member
60A Opening
61 Plate member
P Vacuum sealed package
G Getter material
E Electronic device
H Heater

**Claims**

1. A vacuum sealed package comprising a package main body portion in which a first main body portion and a second main body portion that serves as a lid member of the first main body portion are bonded via a hollow portion, and a getter material and an electronic device that are provided within the hollow portion of the package main body portion, an inside of the package main body portion being sealed with a sealing member in a state of the hollow portion being evacuated via a through-hole that brings an inside of the hollow portion and an outside of the package main body portion into communication, wherein:

   the first main body portion includes a wiring substrate;
   the getter material and the electronic device are respectively connected to a first conductor pad and a second conductor pad that are positioned in the hollow portion and formed on the wiring substrate;
   the first conductor pad is connected via a thermally conductive material with a third conductor pad that is positioned outside of the hollow portion and formed on the wiring substrate; and
   the second conductor pad is electrically connected with a fourth conductor pad that is positioned outside of the hollow portion and formed on the wiring substrate.

2. The vacuum sealed package according to claim 1, wherein the thermally conductive material is a metal material.

3. The vacuum sealed package according to claim 1 or claim 2, wherein a periphery of the thermally conductive material is surrounded with an insulating material.

4. The vacuum sealed package according to claim 3, wherein the insulating material is any one of glass ceramics, alumina, and glass.

5. A vacuum sealed package comprising a package main body portion in which a first main body portion and a second main body portion that includes an infrared ray transmissive window are bonded via a hollow portion, and a getter material and an electronic device that are provided within the hollow portion of the package main body portion, in a state of the hollow portion being evacuated via a through-hole that brings an inside of the hollow portion and an outside of the package main body portion into communication, the through-hole being sealed with a sealing member, wherein:

   at least one portion of the getter material is mounted at a position so as to be contactable with a laser beam that is emitted from the outside of the package main body portion, passes through the infrared ray transmissive window, and reaches the hollow portion; and
   the sealing member is formed by partially heating vicinity of the through-hole of the package main body portion so as to melt the vicinity of the through-hole.

6. The vacuum sealed package according to claim 5, wherein the getter material is arranged in the hollow portion, and is mounted or film-formed on at least one location among surfaces of the first main body portion, the infrared ray transmissive window, and the second main body portion.

7. The vacuum sealed package according to claim 5 or claim 6, wherein the sealing member includes a low-melting-point material having a lower melting point than a material of the package main body portion.

8. The vacuum sealed package according to any one of claim 5 to claim 7, wherein the sealing member in the vicinity of the through-hole is partially heated and melted by a laser beam.

9. The vacuum sealed package according to any one of claim 5 to claim 8, wherein a low-melting-point portion that includes a low-melting-point metal having a melting point lower than the package main body portion is provided in the vicinity of the through-hole; and
   the low-melting-point portion forms the sealing member that plugs the through-hole by the vicinity of the through-hole being partially heated and melted.

10. The vacuum sealed package according to claim 9, wherein the low-melting-point portion is partially heated and melted by a laser beam.

11. The vacuum sealed package according to any one of claim 5 to claim 10, wherein material that serves as the sealing member is Sn or an alloy material that includes Sn.

12. A vacuum sealed package comprising a package main body portion in which a first main body portion and a second main body portion are bonded via a hollow portion, and a getter material and an electronic device that are provided within the hollow portion of the package main body portion, an inside of the package main body portion being sealed with a sealing member in a state of the hollow portion being evacuated via a through-hole that brings an inside of the hollow portion and an outside of the package main body portion into communication, wherein:

a low-melting-point portion that includes a low-melting-point material having a melting point lower than the package main body portion is provided in vicinity of the through-hole, and in the through-hole is provided the sealing member that plugs the through-hole in a vacuum by the low-melting-point portion in the vicinity of the through-hole being partially heated and the low-melting-point portion being melted;
the getter material is mounted or film-formed in the vicinity of the through-hole and on an inner surface of the hollow portion of the package main body portion; and
a distance between the getter material and the through-hole is set to a distance in which the low-melting-point portion can melt by residual heat of heat that occurs by heating the getter material.

13. The vacuum sealed package according to claim 12, wherein the through-hole is formed in the second main body portion, and the low-melting-point portion is formed on an entire surface of the second main body portion including an inner periphery of the through-hole.

14. The vacuum sealed package according to claim 12 or claim 13, wherein the low-melting-point portion is partially heated and melted by a laser beam, a thickness of the low-melting-point portion is designed so that a volume of the low-melting-point portion to be melted is equal to or greater than a volume of the through-hole, and a spot diameter of the laser beam is set so as to be greater than a diameter of the through-hole.

15. The vacuum sealed package according to any one of claim 12 to claim 14, wherein the low-melting-point portion is Sn or an alloy material that includes Sn.

16. The vacuum sealed package according to any one of claim 1 to claim 15, wherein the through-hole is formed in a tapered shape in which a diameter gradually becomes smaller from a surface of the package main body portion to an opposite side surface thereof.

17. The vacuum sealed package according to any one of claim 1 to claim 15, wherein the through-hole is formed in a tapered shape in which a diameter gradually becomes smaller from a surface of the package main body portion toward center in a depth direction of the through-hole.

18. The vacuum sealed package according to any one of claim 1 to claim 15, wherein the through-hole is obliquely formed with respect to a thickness direction of the package main body portion.

19. The vacuum sealed package according to any one of claim 1 to claim 18, wherein the second main body portion includes a frame member that is formed in a frame shape and a plate member that is formed in a plate shape, and the plate member and the frame member are bonded so that the plate member blocks an opening of the frame member.

20. The vacuum sealed package according to any one of claim 1 to claim 19, wherein the electronic device is an infrared ray receiving element, an infrared ray transmissive hole is provided at the portion of the package main body portion facing at least the light receiving portion of the infrared ray receiving element, and an infrared ray transmissive window material is bonded so as to block the infrared ray transmissive hole.

21. The vacuum sealed package according to any one of claim 1 to claim 20, wherein the package main body portion includes a wiring substrate, and the electronic device is electrically connected to the wiring substrate.

22. The vacuum sealed package according to any one of claim 1 to claim 21, wherein the electronic device or the infrared ray receiving element is mounted on the wiring substrate so that a circuit surface thereof faces upward, and at a surface of the wiring substrate a metal material is formed between the electronic device or the infrared ray receiving element and the wiring substrate.

23. The vacuum sealed package according to any one of claim 1 to claim 22, wherein a continuous conductor pattern that encloses a periphery of the electronic device is formed on a surface on the wiring substrate, and a width of the conductor pattern is wider than a bonding width of a structure to be bonded with the wiring substrate.

24. The vacuum sealed package according to any one of claim 1 to claim 23, wherein an external terminal that is electrically connected with the electronic device is provided on a same surface of the wiring substrate as a surface that the electronic device or infrared ray receiving element is provided on, and inside and outside of the hollow portion.

25. The vacuum sealed package according to any one of claim 1 to claim 24, wherein an external terminal that is electrically connected with the electronic device is provided on a reverse-opposite surface of a surface of the wiring substrate on which the electronic device or infrared ray receiving element is provided.

26. The vacuum sealed package according to any one of claim 1 to claim 25, wherein Au is formed on at least either one of a surface of a conductor pattern that is formed on the wiring substrate and a surface of an external terminal.

27. The vacuum sealed package according to any one of claim 1 to claim 26, wherein a ceramics material or Si is used for a base material of the wiring substrate.

28. The vacuum sealed package according to any one of claim 1 to claim 27, wherein the package main body portion excluding the wiring substrate includes an alloy material that includes at least Ni.

29. The vacuum sealed package according to any one of claim 1 to claim 28, wherein the package main body portion includes a semiconductor material, a metal such as Ni, Fe, Co, Cr, Ti, Au, Ag, Cu, Al, Pd, Pt or the like, an alloy having one of these metals as a main component, or a glass or ceramics material.

30. A printed circuit board comprising the vacuum sealed package according to any one of claim 1 to claim 29.

31. An electronic device comprising the vacuum sealed package according to any one of claim 1 to claim 29, or the printed circuit board according to claim 30.

32. A method for manufacturing a vacuum sealed package comprising a package main body portion constituted by a first main body portion and a second main body portion bonded via a hollow portion, and an electronic device and a getter material that are provided within the hollow portion of the package main body portion, the method comprising:

connecting the getter material to a first conductor pad that is positioned in the hollow portion on a wiring substrate that is provided in the first main body portion;
electrically connecting the electronic device to a second conductor pad that is positioned in the hollow portion on the wiring substrate;
bonding the second main body portion to the first main body portion in which the getter material and the electronic device are provided so that the getter material and the electronic device are disposed in the hollow portion;
evacuating the hollow portion via a through-hole that is formed in the second main body portion, in the state of the first main body portion and the second main body portion being bonded;
indirectly heating and activating the getter material by heating a third conductor pad that is positioned on the wiring substrate outside of the hollow portion and connected via the first electrode pad and a thermally conductive material; and
plugging the through-hole.

33. The method for manufacturing a vacuum sealed package according to claim 32, wherein the heating of the third conductor pad is performed by emitting a laser beam onto the third conductor pad.

34. The method for manufacturing a vacuum sealed package according to claim 32, wherein the heating of the third conductor pad is performed by bringing a heat source into contact with the third conductor pad.

35. A method for manufacturing a vacuum sealed package comprising a package main body portion constituted by a first main body portion and a second main body portion that includes an infrared ray transmissive window material bonded via a hollow portion, and an electronic device and a getter material that are provided within the hollow portion of the package main body portion, the method comprising:

mounting an electronic device on the first main body portion;
mounting or film-forming the getter material in the hollow portion at any location among the first main body portion, the infrared ray transmissive window, and the second main body portion;
bonding the second main body portion to the first main body portion so that the electronic device is arranged in the hollow portion;
evacuating the hollow portion via a through-hole that is formed in the second main body portion, in a state of the first main body portion and the second main body portion being bonded;
emitting a laser beam through the infrared ray transmissive window to heat and activate the getter material; and
plugging the through-hole by partially heating vicinity of the through-hole that is formed in the second main body portion to melt the second main body portion.

**36.** The method for manufacturing a vacuum sealed package according to any one of claim 32 to claim 35, wherein the through-hole is plugged by partially heating a low-melting-point portion that is provided in vicinity of a through-hole that is formed in the second main body portion and that has a melting point lower than the second main body portion, to thereby melting the low-melting-point portion.

**37.** A method for manufacturing a vacuum sealed package comprising a package main body portion constituted by a first main body portion and a second main body portion bonded via a hollow portion, and an electronic device and a getter material that are provided within the hollow portion of the package main body portion, the method comprising:

mounting the electronic device on the first main body portion;

mounting or film-forming the getter material in vicinity of a through-hole for vacuum evacuation that is provided in the second main body portion;

bonding the first main body portion and the second main body portion so that the electronic device and the getter material are disposed in the hollow portion;

evacuating an inside of the hollow portion via the through-hole that is formed in the second main body portion, in a state of the first main body portion and the second main body portion being bonded;

heating the getter material; and

plugging the through-hole in a vacuum by melting a low-melting-point portion that is formed at a periphery of the through-hole and that has a melting point lower than a material that constitutes the second main body portion while heating the getter material.

**38.** The method for manufacturing a vacuum sealed package according to any one of claim 32 to claim 37, further comprising, prior to plugging the through-hole, heating the package main body portion to 100°C or more while evacuating the hollow portion of the package main body portion.

# FIG. 1

# FIG. 2

# FIG. 3

# FIG. 4

# FIG. 5

FIG. 6

FIG. 7

FIG. 8

FIG. 9

## FIG. 10

## FIG. 11

## FIG. 12

# FIG. 13

# FIG. 14

# FIG. 15

## FIG. 16

## FIG. 17

## FIG. 18

# FIG. 19

# FIG. 20

FIG. 21

EP 2 400 540 A1

FIG. 22

EP 2 400 540 A1

# FIG. 23

# FIG. 24

FIG. 25

FIG. 26A

FIG. 26B

# FIG. 27

# FIG. 28

## FIG. 29

## FIG. 30

## FIG. 31

# FIG. 32

FIG. 33

FIG. 34

# FIG. 35

EP 2 400 540 A1

## FIG. 36

FIG. 37

EP 2 400 540 A1

# FIG. 38

FIG. 39

EP 2 400 540 A1

# FIG. 40

# FIG. 41

# FIG. 42

EP 2 400 540 A1

FIG. 43

FIG. 44

EP 2 400 540 A1

# FIG. 45

EP 2 400 540 A1

# FIG. 46

# FIG. 47

EP 2 400 540 A1

# FIG. 48

# FIG. 49

# FIG. 50

EP 2 400 540 A1

# FIG. 51

# FIG. 52

# FIG. 53

# FIG. 54

# FIG. 55

45

# FIG. 56

61      31

5

# FIG. 57

60      31

60A

# FIG. 58

# FIG. 59

# FIG. 60

# FIG. 61

# FIG. 62

# FIG. 63

# FIG. 64

# FIG. 65

INFRARED RAY

# FIG. 66

# FIG. 67

# FIG. 68

# FIG. 69

# FIG. 70

## INTERNATIONAL SEARCH REPORT

| | International application No. |
|---|---|
| | PCT/JP2010/000451 |

A.   CLASSIFICATION OF SUBJECT MATTER
*H01L23/02*(2006.01)i, *G01J1/02*(2006.01)i, *H01L23/26*(2006.01)i

According to International Patent Classification (IPC) or to both national classification and IPC

B.   FIELDS SEARCHED

Minimum documentation searched (classification system followed by classification symbols)
H01L23/02, G01J1/02, H01L23/26

Documentation searched other than minimum documentation to the extent that such documents are included in the fields searched
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2003-254820 A  (Mitsubishi Electric Corp.),<br>10 September 2003 (10.09.2003),<br>entire text; all drawings<br>(Family: none) | 1-2,19-34,38<br>16-18,36<br>3-4 |
| Y | JP 2007-214315 A  (Citizen Holdings Co., Ltd.),<br>23 August 2007 (23.08.2007),<br>entire text; all drawings<br>& US 2007/0182289 A1 | 16-18,36 |

☐  Further documents are listed in the continuation of Box C.            ☐  See patent family annex.

| | |
|---|---|
| *      Special categories of cited documents: | "T"   later document published after the international filing date or priority date and not in conflict with the application but cited to understand the principle or theory underlying the invention |
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search | Date of mailing of the international search report |
|---|---|
| 20 April, 2010 (20.04.10) | 27 April, 2010 (27.04.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

| INTERNATIONAL SEARCH REPORT | International application No. |
| --- | --- |
| | PCT/JP2010/000451 |

**Box No. II     Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III     Observations where unity of invention is lacking (Continuation of item 3 of first sheet)**

This International Searching Authority found multiple inventions in this international application, as follows:
It is not considered that the invention in claim 1 and the inventions in claims 5 - 11, 35 have a technical relationship therebetween expressed by any special technical feature identical or corresponding to each other.
Consequently, it cannot be recognized that the invention in claim 1 and the inventions in claims 5 - 11, 35 are deemed to constitute a group of inventions so linked as to form a single general inventive concept.

(continued to extra sheet)

1. ☐ As all required additional search fees were timely paid by the applicant, this international search report covers all searchable claims.

2. ☐ As all searchable claims could be searched without effort justifying additional fees, this Authority did not invite payment of additional fees.

3. ☒ As only some of the required additional search fees were timely paid by the applicant, this international search report covers only those claims for which fees were paid, specifically claims Nos.:
   1 - 4, 16 - 34, 36, 38

4. ☐ No required additional search fees were timely paid by the applicant.   Consequently, this international search report is restricted to the invention first mentioned in the claims; it is covered by claims Nos.:

**Remark on Protest**     ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

**INTERNATIONAL SEARCH REPORT**

International application No.

PCT/JP2010/000451

Continuation of Box No.III of continuation of first sheet(2)

Furthermore, it is also not considered that the invention in claim 1 and the inventions in claims 12 - 15, 37 have a technical relationship therebetween expressed by any special technical feature identical or corresponding to each other.
Consequently, it cannot be recognized that the invention in claim 1 and the inventions in claims 12 - 15, 37 are deemed to constitute a group of inventions so linked as to form a single general inventive concept.

Form PCT/ISA/210 (extra sheet) (July 2009)

**EP 2 400 540 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003139616 A
- JP H11326037 B
- JP 2006010405 A
- JP 2007073721 A
- JP 2009036511 A